# EUROPÄISCHE PATENTSCHRIFT

(11) **EP 2 606 315 B1**
(45) Veröffentlichungstag und Bekanntmachung des Hinweises auf die Patenterteilung: **09.01.2019**
(21) Anmeldenummer: 11748875.9
(22) Anmeldetag: 19.08.2011
(51) Int. Cl.: G01D 5/347, G01D 5/244, H01L 31/0203

(54) **POSITIONSMESSVORRICHTUNG**
POSITION MEASURING DEVICE
DISPOSITIF DE MESURE DE POSITION

(30) Priorität: 19.08.2010 CH 13422010; 20.08.2010 CH 13432010; 19.08.2010 CH 13412010
(43) Veröffentlichungstag der Anmeldung: 26.06.2013
(73) Patentinhaber: ELESTA GmbH, 7310 Bad Ragaz (CH)
(72) Erfinder: WAGNER, Jean-Jacques, FL-9493 Mauren (LI)
(74) Vertreter: Hasler, Erich
(86) Internationale Anmeldenummer: PCT/CH2011/000187
(87) Internationale Veröffentlichungsnummer: WO 2012/022002

(56) Entgegenhaltungen:
- EP-A2- 1 041 628
- EP-A2- 1 528 367
- EP-A2- 1 788 361
- EP-A2- 2 063 231
- DE-A1- 19 859 670
- DE-A1-102004 027 226

## Beschreibung

Die Erfindung betrifft eine Positionsmessvorrichtung gemäss Oberbegriff von Anspruch 1.

### Stand der Technik:

Aus der US Patentanmeldung Nr. 2006/0007541 ist ein Sensorkopf eines mit reflektiertem Licht arbeitenden Sensors bekannt. Dieser Sensorkopf besitzt eine Lichtquelle, welche einen Lichtstrahl auf eine Massverkörperung projiziert, und zwei Halbleitersubstrate. Die Halbleitersubstrate umfassen jeweils Photodetektoren, um Licht zu detektieren, welches durch die Massverkörperung reflektiert wird. Lichtquelle und Halbleitersubstrate sind in einem schachtelartigen Gehäuse angeordnet, wobei die Lichtquelle am Boden des Gehäuses und die Halbleitersubstrate am Deckel, mit welchem das Gehäuse verschliessbar ist, angeordnet und befestigt sind. Die Halbleitersubstrate sind mittels Wende - Montage am Deckel festgemacht.

Die Halbleitersubstrate mit den Photodetektoren sind einander gegenüberliegend auf beiden Seiten der Lichtquelle in einer Richtung angeordnet, welche senkrecht zur Bewegungsrichtung der Massverkörperung steht. Jedes Halbleitersubstrat besitzt eine elektrische Schaltung, und die elektrischen Schaltungen beider Halbleitersubstrate sind miteinander durch elektrische Leitungen verbunden, welche auf der Unterseite des Deckels ausgebildet sind. StromSpannungswandler sind direkt auf den Halbleitersubstraten ausgebildet, um Störeinflüsse möglichst gering zu halten. Ein Nachteil des vorbekannten Sensorkopfes ist dessen aufwendige Herstellung. Dabei müssen zuerst die Halbleitersubstrate hergestellt und danach am Gehäusedeckel befestigt werden. Dann wird die Lichtquelle am Boden des Gehäuses angeordnet und befestigt. Zuletzt wird der Deckel auf dem Gehäuse so angebracht, dass die Lichtquelle zum Halbleitersubstrat korrekt ausgerichtet ist. Dies muss mit der erforderlichen Präzision erfolgen, damit bei der relativen Bewegung der Massverkörperung Signale (insbesondere die durch das Sensorsystem aufzuarbeitenden Analogsignale) einer ausreichenden Qualität erhalten werden können, so dass der Encoder einwandfrei funktioniert. Auch ist die Herstellung der elektrischen Verbindungen zu den beiden Halbleitersubstraten kompliziert und aufwendig. Ausserdem ist eine Miniaturisierung des Sensorkopfs ohne Verlust an Signalqualität nicht realisierbar.

Die DE 10357654 zeigt den Aufbau eines Dünnschichtsensors für einen Encoder, der für das Ablesen einer inkrementalen Spur geeignet ist. Der Sensor weist zwei Kanäle A und B auf und es ist eine grosse Anzahl von miteinander verschalteten Dioden vorgesehen. Die Schichtdicke der metallischen Schicht von 80 nm ist nicht ausreichend für das Anbringen von Stud-Bumps (dazu würden etwa 1000 nm Aluminium benötigt). Eine Klebeverbindung ist ebenfalls nicht möglich, da diese auf Chrom oder Aluminium keine guten Verbindung gewährleistet.

Die DE 10129334 zeigt eine weitere Anordnung von Lichtempfängern die voneinander isoliert sind, in dem die Zwischenräume zwischen den nebeneinanderliegenden Lichtsensoren vollständig weggeätzt werden. Diese Anordnung hat einen wesentlichen Nachteil, der sich während der Fertigung zeigen würde: Während des Ätzens des amorphen Siliziums sind Unterätzungen im i Bereich unvermeidlich. Bei solchen Unterätzungen besteht die ständige Gefahr von Kurzschlüssen zwischen der metallischen Schicht und der TCO-Schicht. Um dies zu verhindern ist eine höhere Sorgfalt bei der Fertigung notwendig, was höhere Kosten verursacht.

DE 198 59 669 zeigt eine Anordnung für einen Encoder, wobei die Lichtempfängerelemente und die Lichtquelle in einem Halbleitersubstrat integriert sind. Es werden zudem zwei Massverkörpe-rungen oder Massstäbe eingesetzt. Der Einsatz von zwei Massverkörperungen und eines geätzten Halbleitermaterials für die Freilegung der Lichtgänge führen zu höheren Kosten.

In der DE 196 43 911 wird ein Flip-Chip Verfahren für optoelektronische Bauelemente beschrieben, wobei die Trägerplatte aus transparentem Material ausgeführt sein kann oder für den Durchtritt des Lichts Aussparrungen vorgesehen sind. Dabei ist es von Nachteil, dass die transparente Trägerplatte für die Abtastung auf beiden Seiten frei sein muss und somit die Signalverarbeitung an einem anderen Ort erfolgen muss. Dies erlaubt keine platzsparende Konstruktion des Sensorkopfs.

Eine Positionsmessvorrichtung gemäß dem Oberbegriff des Anspruchs 1 ist in der EP 1 788 361 beschrieben.

### Aufgabe:

Die Vorrichtung soll in ihren Abmessungen möglichst kompakt sein, damit sie sich für den Bau von kleinen Encodern eignet. Trotz der sehr kompakten Bauform soll sie jedoch in der Lage sein, eine genaue Bestimmung der Position zu ermöglichen, was voraussetzt, dass ein qualitativ gutes Grundsignal erzeugt wird.

Ein weiteres Ziel der vorliegenden Erfindung ist es, eine Positionsmessvorrichtung bereitzustellen, welche kostengünstig herzustellen ist. Die Konstruktion der Vorrichtung soll sie darüber hinaus gegen Umwelteinflüsse unempfindlich machen. Sie soll zudem einen geringen Energiebedarf aufweisen, d.h. für den Betrieb mit Batterien geeignet sein.

### Beschreibung:

Die oben genannte Aufgabe wird durch eine Positionsmessvorrichtung gemäss Anspruch 1 gelöst.

Durch den Einsatz einer Massverkörperung mit optischen Elementen, die die gesamte auf die einzelnen Teilungen fallende Lichtenergie für die Bildung des Grundsignals zur Verfügung stellen, und durch die kompakte Bauform des Sensorkopfs, welche kurze Lichtwege zwischen Lichtquelle und Lichtempfänger schafft, ist ein sparsamer Umgang mit der Lichtenergie ermöglicht.

Die Funktion des Sensorkopfs ist durch einen Lithographieschritt festgelegt, durch den eine Lichtquelle und Lichtempfängerelemente und auf dem Glassubstrat gebildet werden. Im FlipChip Verfahren wird das Glassubstrat auf der Trägerplatte angeordnet. Die Lichtempfängerelemente werden über Stud-Bumps und Leiterbahnen direkt mit einer auf der Rückseite der Trägerplatte angeordneten Auswerteschaltung verbunden.

Um gute Grundsignale zu erzeugen, ist eine spezielle Anordnung der Lichtempfängerelemente vorgesehen. Diese werden nach dem Muster A+b-a-B+ aneinandergereiht. Eine sorgfältige Gestaltung der Lichtempfänger ist notwendig für eine korrekte Verteilung der Schwerpunkte der Lichtempfängerelemente. Zudem spielt die spezielle Formgebung - insbesondere beim Sensorbereich für den Index - eine entscheidende Rolle.

Eine kompakte Bauform wird durch die Verwendung der FlipChip-Montage und weitere Vorkehrungen ermöglicht. Dies sind z.B. die Wahl der metallischen Oberschicht der Lichtempfängerelementen, die Verwendung von Stud-Bumps für eine stabile elektrische Verbindung (für ein stabiles Grundsignal) und die Verwendung einer Klebtechnik, wobei eine eher ungewöhnlicher Permanentresist ein sicheres Kleben erlaubt. Es ist bei dieser Konstruktionsweise möglich, bei niedrigen Temperaturen zu arbeiten, was die Lichtempfänger schont.

Dank dieser Vorkehrungen wird es möglich einen 3 Kanal Encoder mit einem Durchmesser von 4 bis 20 mm zu bauen. Dank der optimalen Gestaltung der Lichtgänge können solche Encoder mit einem Strombedarf von weniger als 3 oder sogar 1 mA funktionieren und höhe Auflösungen zu einem angemessenen Preis erreichen.

Nachfolgend werden Ausgestaltungsformen der Positionsmessvorrichtung beschrieben, wobei die genannten bevorzugten Merkmale - soweit sie sich nicht ausschliessen - in beliebiger Kombination verwirklicht sein können.

Nach einer bevorzugten Ausgestaltungsform handelt es sich um eine Positionsmessvorrichtung mit
- mindestens einer Maßverkörperung mit einer optischen Struktur, vorzugsweise einer Anordnung von 3-D Reflektoren,
- einer im Abstand von der Maßverkörperung angeordneten Lichtquelle und
- wenigstens einem im Abstand von der Maßverkörperung angeordneten Lichtempfänger, sowie
- mindestens einem zwischen der Maßverkörperung und dem Lichtempfänger vorhandenen transparenten Substrat,
- wobei auf der der Maßverkörperung abgewandten Seite des Substrats der Lichtempfänger in Gestalt eines Dünnschichtaufbaus bestehend aus mehreren übereinander angeordneten Schichten direkt auf das transparente Substrat abgeschieden ist,
- wobei im Abstand vom Lichtempfänger eine Lichtquelle vorgesehen ist, und
- wobei eine Trägerplatte vorgesehen ist, auf welcher das Substrat angeordnet ist.

Der Lichtempfänger hat also mit Vorteil die Gestalt eines Dünnschichtsensors. In den erwähnten Schichten ist eine Aussparung für eine Lichtquelle vorgesehen. Die Lichtquelle wird vorzugsweise so ausgebildet, dass sie mit den Prozessen zur Herstellung der Sensoren (Lichtempfängerelemente) mit gefertigt wird, so dass die Abmessungen und Position der Lichtempfänger und der Lichtquelle durch eine Lithographiemaske vorgegeben sind. Dabei kann die Lichtquelle durch eine Blende und eine LED oder durch eine direkt auf dem Substrat abgeschiedene OLED gebildet sein. Im Unterschied zum eingangs beschriebenen Stand der Technik sind somit keine weiteren Justierarbeiten notwendig, was die Herstellung der Positionsmessvorrichtung wesentlich vereinfacht, aber auch zuverlässiger macht. Die Lichtquelle ist vorzugsweise hinter einer in den erwähnten Schichten ausgeätzten Aussparung oder Blende angeordnet.

Weiterhin kann eine Auswerteschaltung vorgesehen sein, die auf der Trägerplatte angeordnet ist.

Bevorzugt weist die Trägerplatte auf beiden Flachseiten Leiterbahnen auf, einerseits für die Kontaktierung mit dem Lichtempfänger und andererseits für die Kontaktierung einer Auswerteschaltung. Darüber hinaus ist es von Vorteil, wenn die Trägerplatte Anschlüsse zum Anschluss der Positionsmessvorrichtung an ein externes Anzeigegerät aufweist.

Das transparente Substrat und die Trägerplatte sind mit Vorteil durch Flip-Chip Montage fest miteinander verbunden. Gemäss einer weiteren vorteilhaften Ausgestaltung ist der Lichtempfänger mit einer metallischen Deckschicht, vorzugsweise aus Aluminium, kontaktiert. Das elektrisch leitende Metall ist vorzugsweise Aluminium, welches bevorzugt mit 1 bis 5 % Titan legiert ist. Darüber hinaus ist es wünschenswert, wenn die elektrische Verbindung zwischen der leitenden Deckschicht und den Leiterbahnen der Trägerplatte mittels Lotkugeln, sogenannten "Bumps" oder "stud-bumps", hergestellt sind. Die Verbindung zwischen der metallischen Deckschicht oder den Bumps einerseits und der Trägerplatte andererseits ist vorzugsweise mittels eines elektrisch leitenden Klebstoffs hergestellt. Gemäss einer weiteren Variante der Erfindung ist zwischen der Trägerplatte und dem Substrat ein Permanentresist zur Begrenzung der Ausdehnung des Klebstoffs vorgesehen.

Der Dünnschichtsensor ist gemäss einer bevorzugten Ausgestaltungsform gebildet durch
- eine transparente, leitende Schicht, vorzugsweise eine transparente, leitende Oxid-Schicht (= TCO- Schicht),
- eine erste dotierte Schicht,
- eine intrinsische Schicht, vorzugsweise eine amorphe Siliziumschicht,
- eine zweite dotierte Schicht sowie
- eine elektrisch leitende, metallische Deckschicht,
wobei die Schichten vorzugsweise in der angegebenen Reihenfolge vorliegen.

In vorteilhafter Weise wird zur Herstellung eines strukturierten Sensorbereiches bereichsweise die Aluminiumschicht, die oberste dotierte Schicht und vorzugsweise zumindest ein Teil der intrinsischen Schicht weggeätzt.

Die erfindungsgemässe Vorrichtung kann sich auch dadurch auszeichnen, dass der Lichtempfänger als Sensorbereich ausgebildet ist bestehend jeweils aus einer Mehrzahl von Lichtempfängerelementen, welche elektrisch miteinander verbunden sind. Vorteilhafterweise sind bei der Vorrichtung wenigstens ein erster und ein zweiter Sensorbereich vorgesehen, welche Bereiche einer Massverkörperung mit einer inkrementalen Spur sowie einer Indexspur oder einer Absolutspur zugeordnet sind.

Der erste Sensorbereich weist bevorzugt erste und zweite Lichtempfängerelemente auf, welche ineinander verschachtelt sind. Weiterhin kann es von Vorteil sein, wenn die ersten und zweiten Lichtempfängerelemente eine ungefähr U-förmige Gestalt haben. Der geometrische Schwerpunkt der ersten und zweiten Lichtempfängerelementen des ersten Sensorbereiches sollten bevorzugt ungefähr auf einer Geraden liegen. Es kann auch vorgesehen sein, dass der erste Sensorbereich jeweils durch eine Mehrzahl von vorzugsweise streifenförmig ausgebildeten Lichtempfängerelementen gebildet ist, welche Lichtempfängerelemente in einem Winkel von vorzugsweise zwischen 0.5 und 15 Grad zueinander und in einer bestimmten Richtung hintereinander angeordnet sind. Die geraden und die (in Bezug auf deren Abfolge) ungeraden Lichtempfängerelemente können dabei jeweils elektrisch leitend miteinander verbunden sein. Nach einer weiteren Ausgestaltungsform der Vorrichtung sind die ersten und/oder die zweiten Lichtempfängerelemente durch eine zusätzlich aufgebrachte, elektrisch leitende Schicht miteinander verbunden, wobei zwischen der Metallschicht und der zusätzlichen, leitenden Schicht eine Isolationsschicht vorgesehen ist. Die ersten und zweiten Lichtempfängerelemente des ersten Sensorbereichs sind bevorzugt so angeordnet, dass zwei um 180 Grad verschobene, alternierende Signale in der Reihenfolge "AbaB" erhalten werden.

Die genannte Vorrichtung kann sich weiter dadurch auszeichnen, dass der zweite Sensorbereich für die Erzeugung eines Indexes vorgesehen ist und ein streifenförmiges, erstes Lichtempfängerelement sowie zwei in einem Winkel vom ersten Lichtempfängerelement abstehende zweiten Lichtempfängerelemente gebildet sind. Der geometrische Schwerpunkt der Fläche des ersten Lichtempfängerelements und der Fläche der beiden zweiten Lichtempfängerelemente des zweiten Sensorbereiches fallen vorteilhafterweise im Wesentlichen zusammen.

Nach einer weiteren bevorzugten Ausgestaltung der erfindungsgemässen Vorrichtung weist die Massverkörperung zwei Spuren mit optischen Elementen auf, wobei eine erste Spur der Erzeugung eines inkrementalen Signals und die zweite Spur der Ermittlung einer Positionszahl oder eines Indexsignals dient.

Einige bevorzugte Merkmale betreffend die Lichtquelle, welche einzeln oder in Kombination verwirklicht sein können, sind die folgenden: Die Lichtquelle kann hinter dem Substrat angeordnet sein. Ausserdem ist es vorteilhaft, wenn es sich bei der Lichtquelle um eine LED handelt. Weiterhin kann die Lichtquelle im Wesentlichen in derselben Ebene wie die Lichtempfänger angeordnet sein. Wünschenswerterweise ist die Lichtquelle, vorzugsweise eine OLED, direkt auf dem Substrat zwischen den Lichtempfängern ausgebildet. Gemäss einer weiteren Ausgestaltung ist die Lichtquelle in einer metallischen Schicht eingebettet, sodass Streulicht abgehalten werden kann. Es kann auch ein Luftspalt im Lichtgang zwischen Lichtquelle und Substrat vorhanden sein.

Nach einer weiteren vorteilhaften Ausgestaltungsform der vorliegenden Erfindung ist die Auswerteschaltung auf der anderen Seite (d.h. auf der von den Lichtempfängern und/oder der Lichtquelle abgewandten Seite) der Trägerplatte in Gestalt einer integrierten Schaltung zur Verarbeitung der Lichtempfänger-Signale (vorzugsweise im Flip-Chip-Verfahren) angeordnet, wobei die Lichtempfänger mit der integrierten Schaltung elektrisch verbunden sind.

Die genannte Trägerplatte besteht vorzugsweise aus Keramik oder aus Kunststoff (z.B. Polyimid). Nach einer weiteren Variante kann die Trägerplatte aus Kunststofffolie, vorzugsweise Polyimidfolie, hergestellt sein.

Ein Verfahren zur Herstellung eines Sensorkopfes für eine Positionsmessvorrichtung kann dann besonders vorteilhaft sein, wenn es folgende Verfahrensschritte aufweist:
a) Aufbringen einer Vielzahl von Gruppen von Lichtempfängern auf ein transparentes Substrat in einem Dünnschichtverfahren, welche Gruppen von Lichtempfängern jeweils der Herstellung eines einzelnen Sensorkopfes dienen,
b) Vorsehen jeweils einer Blende für eine Gruppe von Lichtempfängern,
c) Aufbringen von Kontaktstellen auf die Lichtempfänger, vorzugsweise in Gestalt von Kugeln, sogenannten "bumps" oder "stud bumps", welche aus Lot oder besser noch aus Gold gefertigt sind, und durch einen Elektrolyse-Prozess aufgebracht werden können (z.B. direkt auf nackte Al-Pads),
d) Bereitstellen einer Trägerplatte mit Leiterbahnen oder Kontaktstellen, welche mit den Kontaktstellen der Lichtempfänger übereinstimmen, und
e) Verbinden des Glassubstrats und der Trägerplatte unter Verwendung eines elektrisch leitenden Klebers.

Das Aufbringen von Kontaktstellen kann auch in Gestalt von Goldkugeln, sogenannten "stud-bumps" erfolgen, oder in Gestalt von Goldabscheidungen oder Gold-/Nickel-Abscheidungen.

Vorgängig kann auf die Trägerplatte eine elektrisch nicht-leitende Schicht aufgebracht werden, welche Aussparungen hat, die mit den Kontaktstellen der Lichtempfänger übereinstimmen. Die Aussparungen können dann mit dem elektrisch leitenden Kleber mindestens teilweise gefüllt werden.

Auf der Rückseite der Trägerplatte kann eine Auswerteschaltung aufgebracht werden.

Weiterhin ist es von Vorteil, wenn ein Teil der vorhandenen Zwischenräume zwischen Glassubstrat und Trägerplatte mit einem Underfill ausgefüllt werden.

Bei der Massverkörperung handelt es sich vorzugsweise um eine Codescheibe bzw. ist eine Codescheibe vorgesehen, die eine genannte Massverkörperung aufweist.

Weiterhin ist eine Positionsmessvorrichtung, dann besonders bevorzugt, wenn er- insbesondere in Kombination mit einem oder mehreren der oben genannten Merkmale - folgende Komponenten aufweist:
- ein Gehäuse,
- einen im Gehäuse angeordneten Sensorkopf mit einer Lichtquelle und einem Lichtempfängerelement,
- eine rotierbare Codescheibe, die an einer Welle einer Vorrichtung, vorzugsweise eines Motors, montierbar ist,
- eine im Abstand vom Sensorkopf vorgesehene, reflektive Massverkörperung mit optischen Elementen, welche Massverkörperung auf der Codescheibe angeordnet ist, wobei die Massverkörperung mit Vorteil auf derjenigen Seite der Codescheibe angeordnet ist, welche vom Gehäuse abgewandt ist.

Der Sensorkopf ist bevorzugt auf einer Leiterplatte montiert, welche formschlüssig mit dem Gehäuse verbunden ist, vorzugsweise über eine Schnappverbindung.

Darüber hinaus ist es wünschenswert, wenn die Positionsmessvorrichtung ein Adapterteil aufweist, welches
- ein erstes Verbindungsmittel zum Verbinden mit der Vorrichtung und
- ein zweites Verbindungsmittel zum formschlüssigen Verbinden mit dem Gehäuse aufweist, wobei es sich beim zweiten Verbindungsmittel um eine Schnappverbindung handelt,
- wobei die Schnappverbindung durch ein oder mehrere Vorsprünge am Adapterteil und ein oder mehrere Vertiefungen am Gehäuse gebildet ist.

Das Gehäuse weist mit Vorteil ein Montagelager auf, in welches die Codescheibe und/oder eine mit der Codescheibe verbundene Aufnahme für eine Welle aufgenommen ist. Beim Montagelager kann es sich beispielsweise um ein Kugellager und insbesondere um ein Teflonlager handeln.

Die Kontaktierung des Sensorkopfs erfolgt gemäss einer bevorzugten Ausgestaltung über eine seitliche Öffnung im Gehäuse, wobei die Öffnung auf der der Codescheibe abgewandten Seite des Sensorkopfs angeordnet ist. Die Kontaktierung kann über ein oder mehrere Kabel erfolgen, welche durch die Öffnung verlaufen, wobei es sich dabei vorzugsweise um Flachkabel und insbesondere um ein Flexprint handelt.

Weiterhin kann es von Vorteil sein, wenn das Gehäuse auf der Seite eine Einbuchtung aufweist, welche sich an die Öffnung anschliesst, wobei sich die Einbuchtung vorzugsweise von der Öffnung entlang der Seite bis zu einer anderen Seite oder einem Rand oder einer Kante des Gehäuses erstreckt und/oder wobei sich die Einbuchtung vorzugsweise von der Öffnung bis zur Oberseite des Gehäuses erstreckt.

Eine ebenfalls bevorzugte Ausgestaltungsvariante sieht vor, dass die Massverkörperung mindestens zwei Spuren aufweist, wobei es sich bei einer Spur um eine Inkrementalspur handelt und wobei es sich bei einer zweiten Spur vorzugsweise entweder um eine Indexspur oder eine Codespur handelt.

Eine Positionsmessvorrichtung (vorzugsweise ein Encoder) kann - insbesondere in Verbindung mit einem oder mehreren der genannten Merkmale - folgende Komponenten aufweisen:
a) ein Gehäuse,
b) ein im Gehäuse angeordneter Sensorkopf mit einem oder mehreren Lichtempfängerelementen, und
c) eine im Abstand vom Sensorkopf vorgesehene, rotierbare Massverkörperung mit optischen Elementen. Die

Massverkörperung ist vorzugsweise auf einer Codescheibe angeordnet, die an einer Welle eines Motors oder einer anderen Vorrichtung montiert sein kann.

Das Lichtempfängerelement ist dabei in einer definierten bzw. vorbestimmten Position relativ zu den optischen Elementen angeordnet und wirkt mit diesen zur Erzeugung eines Signals zusammen. Erfindungsgemäss ist die genannte definierte Position des Lichtempfängerelements relativ zu den optischen Elementen durch einen Sensorkopfhalter festgelegt, welcher mit dem Sensorkopf formschlüssig zusammenwirkt. Bevorzugt wirkt der Sensorkopfhalter auch mit dem Gehäuse formschlüssig zusammen. Weiterhin ist es bevorzugt, wenn das Gehäuse in einer definierten Position relativ zur Massverkörperung und/oder zu den optischen Elementen angeordnet ist.

In diesem Fall kann es sich beim Sensorkopfhalter um den beschriebenen Träger handeln, auf welchem der Sensorkopf angeordnet ist und welcher zwecks Bewegen des Sensorkopfes in Wirkverbindung mit einem Motor steht. Der Begriff "Position" bezieht sich in diesem Dokument vorzugsweise auf den Abstand und/oder die Ausrichtung des angesprochenen Vorrichtungsteils, insbesondere relativ zu anderen Vorrichtungsteilen. Die Abweichung von den definierten Postionen ist mit Vorteil kleiner als 0,2 mm, vorzugsweise kleiner als 0,1 mm und besonders bevorzugt kleiner als 0,05 oder 0,02 mm. Das bedeutet, die entsprechenden Vorrichtungsteile sind mit der genannten Genauigkeit gefertigt.

Nach einer vorteilhaften Ausgestaltung zeichnet sich die Positionsmessvorrichtung dadurch aus, dass das Lichtempfängerelement auf einem Substrat angeordnet ist, dessen Rand mit dem Sensorkopfhalter formschlüssig zusammenwirkt. Weiterhin ist es bevorzugt, wenn das Lichtempfängerelement mittels eines Dünnschichtverfahrens auf das Substrat aufgebracht ist. Beim Substrat handelt es sich mit Vorteil um ein transparentes Substrat und besonders bevorzugt um ein Glassubstrat.

Wenn das Lichtempfängerelement bzw. die Lichtempfängerelemente auf einem Substrat angebracht werden, dann kann bereits beim Herstellungsverfahren die exakte Position der Lichtempfängerelemente relativ zum Rand des Substrats und damit zu einem Teil des Sensorkopfs festgelegt werden. Besonders leicht lassen sich Lichtempfängerelemente mittels Dünnschichtverfahren aufbringen. Dabei wird eine Substratplatte mit einer Vielzahl an Lichtempfängerelementen versehen und anschliessend in kleinere Einheiten (Substrate) zerteilt. Dieses Zerteilen kann sehr exakt durchgeführt werden, z.B. durch Sägen der Substratplatte. Dadurch ergibt sich eine definierte Position der Lichtempfängerelemente relativ zum Rand der Substrate, also dem Ort an dem die Teilung stattgefunden hat.

Es ist von Vorteil, wenn der Sensorkopfhalter ein erstes Strukturelement aufweist, welches formschlüssig mit dem Sensorkopf zusammenwirkt, wobei es sich beim ersten Strukturelement vorzugsweise um eine Öffnung handelt. Weiterhin ist es vorteilhaft, wenn der Sensorkopfhalter ein zweites Strukturelement aufweist, welches formschlüssig mit dem Gehäuse zusammenwirkt, wobei es sich beim zweiten Strukturelement vorzugsweise um den Rand des Sensorkopfhalters handelt. Das erste Strukturelement ist dabei mit Vorteil in einer definierten Position relativ zum zweiten Strukturelement angeordnet. Das erste Strukturelement kann nun formschlüssig mit dem Rand des Substrats zusammenwirken.

Das heisst, die Position der Lichtempfängerelemente relativ zu den optischen Elementen auf der Massverkörperung wird vorzugsweise über mehrere, in ihren Abmessungen aufeinander abgestimmte Vorrichtungsteile (Substrat, Sensorkopfhalter, Gehäuse, Massverkörperung) festgelegt. Der Vorteil besteht darin, dass eine mechanische Justierung beim Zusammenbau entfällt. Der Sensorkopfhalter wirkt also gleichsam als Adapter. Der Sensorkopfhalter kann als Teil des Gehäuses und/oder des weiter unten genannten Deckels ausgeführt sein. Es ist jedoch bevorzugt, wenn der Sensorkopfhalter als separates Vorrichtungsteil ausgeführt ist, denn dadurch wird die Herstellung und Montage erleichtert.

Nach einer vorteilhaften Ausgestaltung der Erfindung ist der Sensorkopfhalter zwischen der Massverkörperung und einem das Gehäuse verschliessenden Deckel angeordnet. Der Deckel steht dabei vorzugsweise in Kontakt mit dem Sensorkopfhalter und fixiert diesen bezüglich dessen Position im Gehäuse. Besonders bevorzugt ist es, wenn im Inneren des Gehäuses ein Rand vorgesehen ist, der eine Auflage für den Sensorkopfhalter bildet und wenn der Sensorkopfhalter zwischen dieser Auflage und dem Deckel fixiert ist.

Bei einem bevorzugten Verfahren zur Herstellung einer Positionsmessvorrichtung, wird ein Sensorkopf, welcher ein oder mehrere Lichtempfängerelemente aufweist, formschlüssig mit einem Sensorkopfhalter verbunden. Der Sensorkopfhalter wird formschlüssig mit einem Gehäuse verbunden. Der Sensorkopfhalter wird dabei vorzugsweise in das Gehäuse eingebracht bzw. eingesetzt. Das Gehäuse wird in einer vorbestimmten bzw. definierten Position relativ zu einer Massverkörperung angeordnet, wobei die Massverkörperung rotierbar ist und optische Elemente aufweist. Dabei sind bzw. werden das Gehäuse, der Sensorkopfhalter und der Sensorkopf so gestaltet werden, dass ihr formschlüssiges Zusammenwirken eine definierte Position des Lichtempfängerelements relativ zu den optischen Elementen festlegt.

Weiterhin kann es von Vorteil sein, wenn beim genannten Verfahren
- das Lichtempfängerelement auf ein Substrat aufgebracht wird,
- der Rand des Substrats mit dem Sensorkopfhalter formschlüssig zusammenwirkt, wenn der Sensorkopf mit dem Sensorkopfhalter verbunden wird,
- das Lichtempfängerelement vorzugsweise mittels eines Dünnschichtverfahrens auf das Substrat aufgebracht wird, und
- es sich beim Substrat vorzugsweise um ein transparentes Substrat und besonders bevorzugt um ein Glassubstrat handelt.

Auch kann es wünschenswert sein, wenn beim erwähnten Verfahren
- der Sensorkopfhalter mit einem erstes Strukturelement ausgebildet wird, welches formschlüssig mit dem Sensorkopf zusammenwirkt, wenn der Sensorkopf mit dem Sensorkopfhalter verbunden wird, wobei es sich beim ersten Strukturelement vorzugsweise um eine (vorzugsweise durchgehenden) Öffnung handelt, und
- der Sensorkopfhalter mit einem zweiten Strukturelement ausgebildet wird, welches formschlüssig mit dem Gehäuse zusammenwirkt, wenn der Sensorkopfhalter mit dem Gehäuse verbunden wird, wobei es sich beim zweiten Strukturelement vorzugsweise um den Rand des Sensorkopfhalters handelt, und
- das erste Strukturelement in einer definierten Position relativ zum zweiten Strukturelement ausgebildet wird. Schliesslich ist es auch wünschenswert, wenn beim Verfahren
- der Sensorkopfhalter im Abstand zur Massverkörperung in das Gehäuse eingesetzt und formschlüssig mit dem Gehäuse verbunden wird,
- auf der der Massverkörperung abgewandten Seite des Sensorkopfhalters das Gehäuse durch einen Deckel verschlossen wird, und
- der Deckel vorzugsweise in Kontakt mit dem Sensorkopfhalter gebracht wird,
- wobei es sich vorzugsweise beim Deckel und/oder beim Gehäuse und/oder beim Sensorkopfhalter um getrennte Vorrichtungsteile handelt.

Dank der kompakten Konstruktion des Sensorkopfes ist es möglich, Drehgeber mit weiteren Eigenschaften zu fertigen, wie zum Beispiel Positionssensoren mit mehreren Sensorköpfen für die redundante Erfassung von Positionswerten. Eine weitere Möglichkeit besteht darin, sehr kompakte Absolutencoder zu bauen, die in der Maßverkörperung einen Manchester-Code oder ähnliche serielle Codes oder einen pseudorandom Code eingebaut haben.

Die genannten Codes können beispielsweise als Binär Codes ausgebildet sein. Durch die Aneinanderreihung von zwei in Bezug auf ihre optische Achse unterschiedlich ausgerichteten optischen Elementen, welche mit geeigneten Empfängerelementen zusammenwirken, können zwei unterschiedliche Zustände bzw. Signale erzeugt werden. Die genannten Signale bzw. Zustände können mit dem Inkrementsignal in Beziehung gesetzt werden. Die Ermittlung eines absoluten Positionswertes wird durch eine relative Bewegung zwischen Sensorkopf und Maßverkörperung möglich gemacht, bei der die Abfolge der optischen Elemente bestimmt wird.

Diese vorteilhaften Eigenschaften werden am besten erreicht, wenn die Maßverkörperung aus halbkreiszylindrischen Reflektoren gebildet ist und die Lichtquelle bestimmte Abmessungen hat. Dies setzt wiederum eine genaue Stellung der Lichtquelle über dem Lichtsensor voraus, um stabile und zuverlässige Signale zu erhalten. Die Bündelung der gesamten auf eine Teilung der Massverkörperung fallende Lichtmenge zusammen mit dem kompakten Sensorkopf machen es möglich, Positionsermittlungseinheiten zu bauen, die eine hohe Lichtausbeute und damit einen geringen Stromverbrauch haben, und die Funktion des Encoders mit weniger Lichtleistung gewährleisten. Die erfindungsgemässe Positionsmessvorrichtungen ist somit für Batteriegeräte bestens einsetzbar.

Die Verwendung eines Dünnschichtaufbaus mit einer intrinsischen Schicht hat den Vorteil, dass zuverlässige Lichtempfänger mit einfachen Mitteln hergestellt werden können wegen der Anwesenheit einer an sich isolierenden Zwischenschicht. Diese Schichten weisen niedrige Dunkelströme auf und sind besonders geeignet für den Bau eines Sensorkopfes für einen Encoder, der mit wenig Strom arbeitet kann.

Weiterhin ist eine Positionsmessvorrichtung (insbesondere ein Encoder) dann besonders bevorzugt, wenn sie - insbesondere in Kombination mit einem oder mehreren der in diesem Dokument genannten Merkmale -folgende Komponenten aufweist:
- einen Support,
- einen am Support angeordneten Sensorkopf mit einer Lichtquelle und einem Lichtempfängerelement,
- eine relativ zum Sensorkopf bewegliche Massverkörperung mit optischen Elementen, die an einen beweglichen Teil einer Vorrichtung, beispielsweise eines Motors, montierbar ist und mit dem Sensorkopf für die Ermittlung eines absoluten Positionswertes zusammenwirken kann,
wobei der Sensorkopf am Support beweglich angeordnet ist, und Mittel vorgesehen sind, um den Sensorkopf relativ zum Support um ein bestimmtes Mass zu verschieben.

Die bewegliche Anordnung des Sensorkopfes am Support hat den Vorteil, dass sich die absolute Position eines beweglichen Teils, z.B. einer Welle oder eines anderen Maschinenteils, in dessen Ruheposition ermitteln lässt. Somit kann beim Maschinenstart die absolute Position des Maschinenteils in kürzester Zeit bestimmt werden, ohne dass eine Bewegung des Maschinenteils selbst notwendig wäre, um z.B. zuerst eine Referenzmarke anzufahren. Hinzu kommt, dass sich in Kombination mit einem weiter unten beschriebenen kompakten Sensorkopf Produkte entwickeln lassen, die wesentlich kleiner und kostengünstiger als aus dem Stand der Technik bekannte Vorrichtungen dieser Art sind.

Vorzugsweise zeichnet sich die Positionsmessvorrichtung dadurch aus, dass die Verschiebemittel zum Bewegen des Sensorkopfes durch einen Motor gebildet sind, welcher in einer Wirkverbindung mit dem Sensorkopf ist.

Weiterhin kann es bevorzugt sein, wenn bei der genannten Positionsmessvorrichtung die Massverkörperung eine Codescheibe ist.

Offenbart sei zudem ein vorteilhaftes Verfahren zur Ermittlung der absoluten Position eines beweglichen Teils in der Ruheposition mit Hilfe einer Positionsmessvorrichtung, welche die Ermittlung der absoluten Position des Teils mit Hilfe einer relativ zu einem Sensorkopf beweglichen Massverkörperung erlaubt, die mit dem beweglichen Teil gekoppelt ist,
dadurch gekennzeichnet,
dass zur Ermittlung der absoluten Position des beweglichen Teils in der Ruheposition der Sensorkopf relativ zum beweglichen Teil verschoben wird.

Die genannten Verfahren können als Verfahrensschritte auch die Verwendung einer oder mehrerer der genannten bevorzugten Merkmale der erfindungsgemässen Vorrichtung (oder die durch diese Merkmale ermöglichten Funktionen) umfassen.

Vorteile der beschriebenen bevorzugten Ausgestaltungsformen der Positionsmessvorrichtung sind:
- Die Möglichkeit, eine Positionsmessvorrichtung kostengünstig in der gewünschten nötigen Präzision herzustellen,
- eine Positionsmessvorrichtung mit kleinsten Abmessungen, mit hoher Genauigkeit sowie Zuverlässigkeit zu bauen. Dies ist insbesondere im medizinischen Bereich bei optischen Untersuchungsgeräten von Vorteil, wo z.B. ein Spiegel exakt positioniert werden muss.
- eine Positionsmessvorrichtung bereit zu stellen, welche eine bestimmte Einbautoleranz toleriert und trotzdem eine zuverlässige Funktion gewährleisten kann und
- eine Positionsmessvorrichtung bereitzustellen, deren Konstruktion gegen Umwelteinflüsse unempfindlich ist.

Vorteilhafte Ausführungsformen der Vorrichtung gehen aus den Merkmalen der abhängigen Ansprüche hervor.

### Figurenbeschreibung:

Die Erfindung wird anhand der Zeichnung und eines Ausführungsbeispiels näher im Detail erläutert. Es zeigt:
- Fig. 1: schematisch und in perspektivischer Ansicht den Prinzipaufbau eines Encoders, bestehend aus einem erfindungsgemäßen Sensorkopf und einer im Abstand vom Sensorkopf vorhandenen Maßverkörperung;
- Fig. 2: schematisch den Aufbau des Sensorkopfes bestehend aus Glassubstrat mit darauf ausgebildeten Sensorbereichen, einer Trägerplatte und einer Auswerteeinheit, welche jeweils im Flip-Chip-Montageverfahren miteinander verbunden sind;
- Fig. 3: die einzelnen Verfahrensschritte zur Herstellung der Sensorbereiche und Kontaktierung derselben; ,
- Fig. 4: die einzelnen Verfahrensschritte zur Auslegung der Lichtquelle;
- Fig. 5: schematisch die Montage der Komponenten auf einem Wafersubstrat;
- Fig. 6: im Schnitt ein praktisches Ausführungsbeispiel eines in einem Gehäuse angeordneten Encoders für Kleinmotoren;
- Fig. 7: schematisch, wie bei einer Relativbewegung von Empfängerelement und Maßverkörperung die vom Empfängerelement registrierten Lichtintensitäten in ein Analogsignal und nachfolgend in ein Digitalsignal für die Positionsbestimmung umgewandelt werden;
- Fig. 8: schematisch die Erzeugung eines Indexsignals mit Hilfe eines einzelnen optischen Elements und zwei Empfängerelementen;
- Fig. 9: schematisch die Erzeugung eines Positionssignals mit Hilfe zweier unterschiedlicher, optischer Elemente, die nach einem Manchester-Code aneinandergereiht sind, und zwei Empfängerelementen;
- Fig. 10: eine Draufsicht auf ein erstes Ausführungsbeispiel eines erfindungsgemässen Sensorkopfes mit einer Mehrzahl von Empfängerelementen mit einer Inkremental- und einer Indexspur;
- Fig. 11: eine Draufsicht auf ein zweites Ausführungsbeispiel eines erfindungsgemässen Sensorkopfes, bei welchem die Empfängerelemente mittels einer separaten Leiterbahn elektrisch verbunden sind;
- Fig. 12: eine Ausführungsform der Erfindung mit einer Lichtquelle mit einer LED, die hinter einer Blende angeordnet ist, wobei die Blende die Abmessungen der Lichtquelle im Wesentlichen bestimmt;
- Fig. 13: eine Schaltung für eine optimale Zuordnung des durch die Maßverkörperung ausgebildeten Indexsignals Zb;
- Fig. 14: ein Ausführungsbeispiel eines Absolutencoders mit Kaltstart Positionsermittlung;
- Fig. 15: eine perspektivische Ansicht eines Kit Encoders mit Motor;
- Fig. 16: eine Rück- und Seitenansicht des Gehäuses mit horizontalem Kabel;
- Fig. 17: eine Schnittdarstellung des Gehäuses des Kit Encoders
- Fig. 18: eine bevorzugte Ausbildung der Wellenaufnahme.

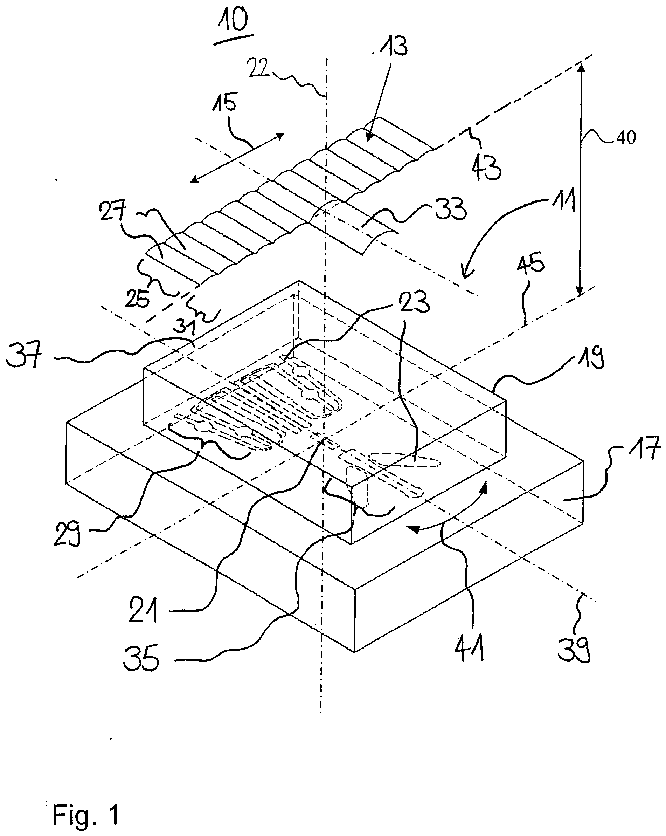

Figur 1 zeigt einen erfindungsgemäßen Encoder 10 umfassend einen Sensorkopf 11 und eine Maßverkörperung 13, die relativ zum Sensorkopf 11 in einer Richtung 15 bewegbar ist. Auf der Rückseite des Sensorkopfes 11 sind der erste und zweite Sensorbereich 29, 35 angeordnet, die im Abstand 40 zur Massverkörperung 13 liegen. Unter Maßverkörperung wird im Rahmen der vorliegenden Erfindung eine Maßeinteilung oder Skala verstanden, welche auf einem Support oder Träger aufgebracht und geeignet ist, einen Lichtstrahl zu reflektieren und zu modulieren, wenn die Maßverkörperung relativ zum Sensorkopf bewegt wird. Eine solche Maßverkörperung kann die Gestalt einer kreisrunden Codescheibe oder eines länglichen Balkens besitzen. Die Maßverkörperung selbst besitzt eine Teilung, wobei jede Teilung per Definition geeignet ist, einen Lichtstrahl zu modulieren, wenn die Teilung durch den Lichtstrahl bewegt wird. Bekannt sind beispielsweise Strukturen, bei denen beispielsweise eine Hälfte der Teilung durchsichtig und die andere Hälfte opak ist. Vorteilhafterweise ist jede Teilung durch ein reflektives optisches Element repräsentiert, welches geeignet ist, einen Lichtstrahl zu bündeln (z.B. Hohlzylinder, Hohlspiegel). Denkbar ist jedoch auch der Einsatz von Gitterstrukturen, wobei deren Effizienz in der Lichtverarbeitung allerdings kleiner wäre als die von Spiegeln, durch welche der Lichtstrahl gebeugt wird.

Der gezeigte Sensorkopf 11 besteht im Wesentlichen aus einer Trägerplatte 17 und einem transparenten Substrat 19, auf dessen Rückseite, d.h. jener Seite, welche der Trägerplatte 17 zugewandt ist, eine Lichtquelle 21 und Lichtempfängerelemente 23 angeordnet sind. Die Lichtquelle 21 sendet einen Lichtstrahl aus, dessen Hauptachse mit der Bezugsziffer 22 bezeichnet ist. Vorzugsweise wird eine Lichtquelle verwendet, welche Licht im sichtbaren Bereich ausstrahlt. Für ein besseres Lichtsignal mit einer kleineren Beugung wäre Licht mit einer Wellenlänge unterhalb von 630 nm, insbesondere 580 und 630 nm, oder unterhalb von 460 nm vorteilhaft. Die Maßverkörperung 13 enthält mindestens eine erste Spur 25 mit ersten optischen Elementen 27, welche mit einem ersten Sensorbereich 29 der Maßverkörperung 13 zusammenwirkt. Neben der ersten Spur 25 ist gemäss dem gezeigten Ausführungsbeispiel eine zweite Spur 31 mit wenigstens einem einzelnen optischen Element 33 vorgesehen. Diese zweite Spur 31 wirkt mit einem zweiten Sensorbereich 35 des Sensorkopfes 11 zusammen. Wie aus Fig. 1 ersichtlich, sind die optischen Elemente 27 der Maßverkörperung in einer Ebene angeordnet, welche im Wesentlichen parallel zu den Flachseiten 37 des Substrats ist. Dabei ist die Maßverkörperung 13 so relativ zum Substrat 19 angeordnet, dass die Spuren 25, 31 jeweils in einer zur Achse 22 des Lichtstrahls parallelen Richtung mit den Sensorbereichen 29,35 übereinstimmen.

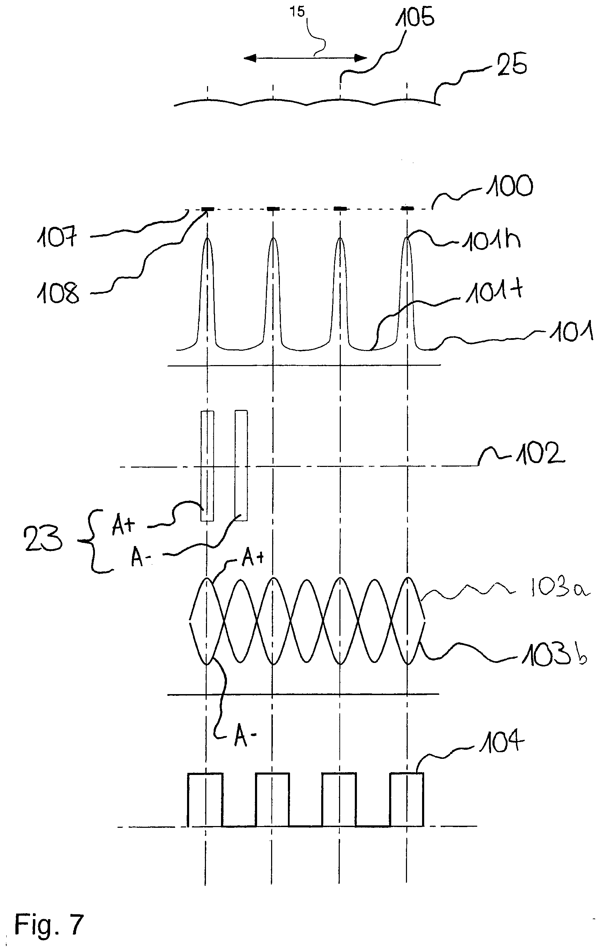

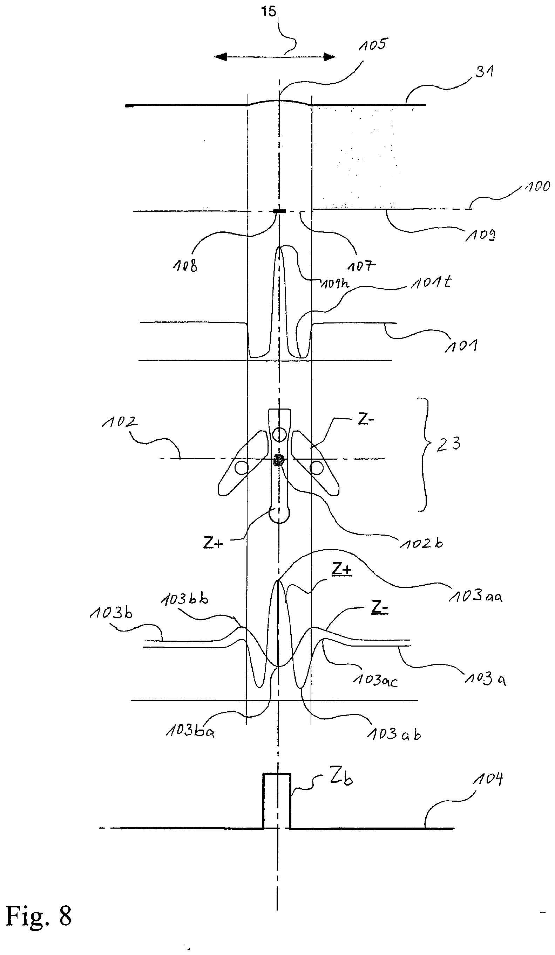

Die optischen Elemente 27,33 sind als fokussierende Linsen oder Spiegel ausgebildet, welche auftreffendes Licht jeweils gebündelt auf den Sensorkopf 11 zurückwerfen. Gemäss dem gezeigten Ausführungsbeispiel besitzen die optischen Elemente 27,33 die Gestalt eines kreisförmigen Halbzylinders. Dabei dient die erste Spur 25 der Erzeugung eines inkrementalen Positionssignals, und die zweite Spur 31 der Erzeugung eines Index-Signals, wie dies weiter unten noch näher beschrieben wird (Beschreibung zu den Figuren 7 und 8).

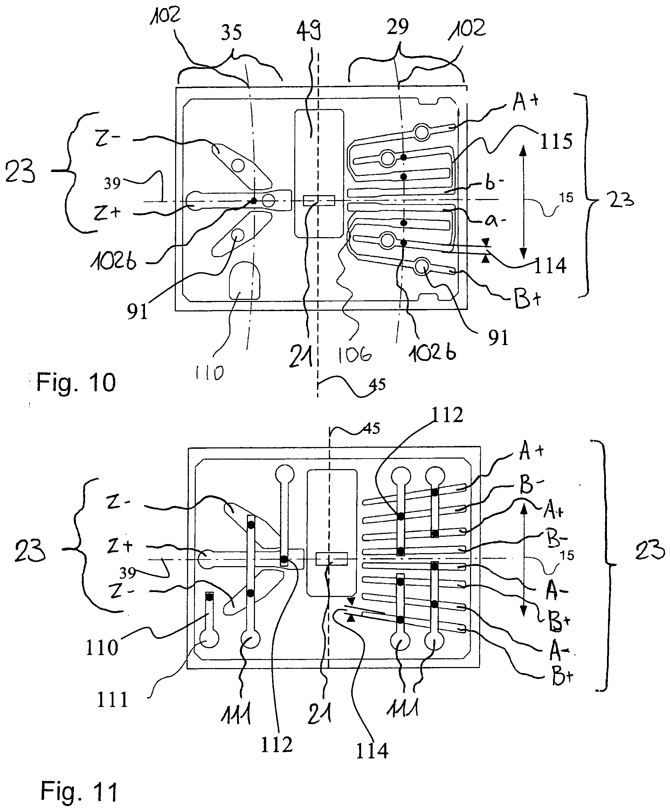

Die Stellung der Maßverkörperung relativ zum Sensorkopf (insbesondere der Abstand 40, vgl. Fig.1) ist üblicherweise mit einer Montagetoleranz behaftet, welche die Güte und Zuverlässigkeit des Messsignals direkt beeinflusst. Bei Montagetoleranz null sind die Flachseiten 37 des Substrats 19 parallel zu einer durch die Maßverkörperung 13 gehenden Ebene, und die Bewegungsrichtung 15 (entspricht einer Tangente an eine Kreisbahn im Falle einer auf einer Kreisscheibe vorgesehenen Maßverkörperung) verläuft rechwinklig zu einer Längsmittelachse 39, welche die Sensorbereiche 29,35 und die Lichtquelle 21 jeweils in zwei Abschnitte teilt. Abweichungen von der genauen relativen Ausrichtung von Maßverkörperung 13 und Substrat 19, welche in Figur 1 durch Pfeil 41 angedeutet sind, können die Positionssignale 104 aus den beiden Spuren 25 und 31 gegeneinander verschieben (siehe weiter unten Beschreibung zu Fig. 10). Bei null Toleranz wird die Mittellinie 43 der Maßverkörperung im Wesentlichen parallel zu einer durch das Zentrum der Lichtquelle 21 gehenden Achse 45 verlaufen, sofern die Sensorbereiche 29,35 symmetrisch zum Zentrum der Lichtquelle angeordnet sind. Bei null Toleranz des Abstands zwischen Maßverkörperung 13 und Sensorkopf 11 ist der Nennabstand vor allem durch die Ausführung der optischen Elemente 27,33 der Maßverkörperung 13 bestimmt. Im Rahmen der vorliegenden Erfindung sind fokussierende optische Elemente und insbesondere dreidimensionale (3D-) Reflektoren besonders bevorzugt, weil diese bezüglich einer Variation des Abstandes zwischen Maßverkörperung 13 und Substrat 19 besonders tolerant sind.

Mit dieser Anordnung lassen sich 3-Kanal Encoder mit der Breite einer Teilung von 18 µm bis 150 µm realisieren. Bei einem Encoder mit einem Gehäusedurchmesser von etwa 20 mm entspricht dies z.B. einer Anzahl Striche auf der Codescheibe von 360 bis 3000 und bei einem Encoder mit einem Gehäusedurchmesser von etwa 6 mm entspräche dies einer Anzahl Striche von 64 bis 380 (ein Strich kann z.B. durch ein optisches Element bzw. eine Teilung definiert sein).

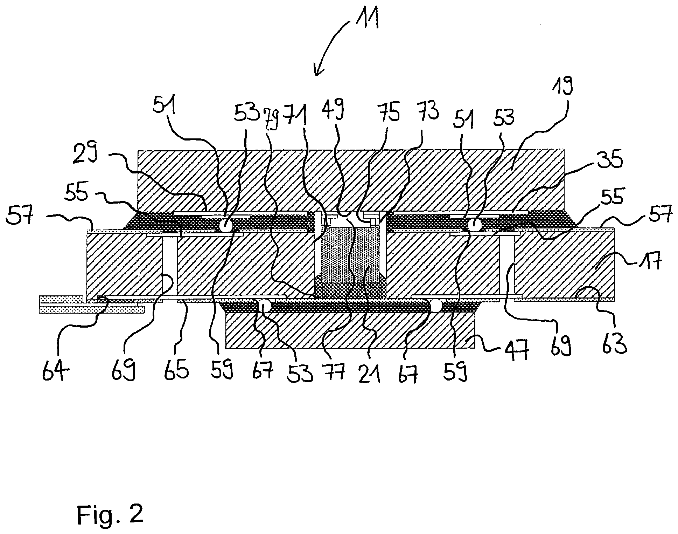

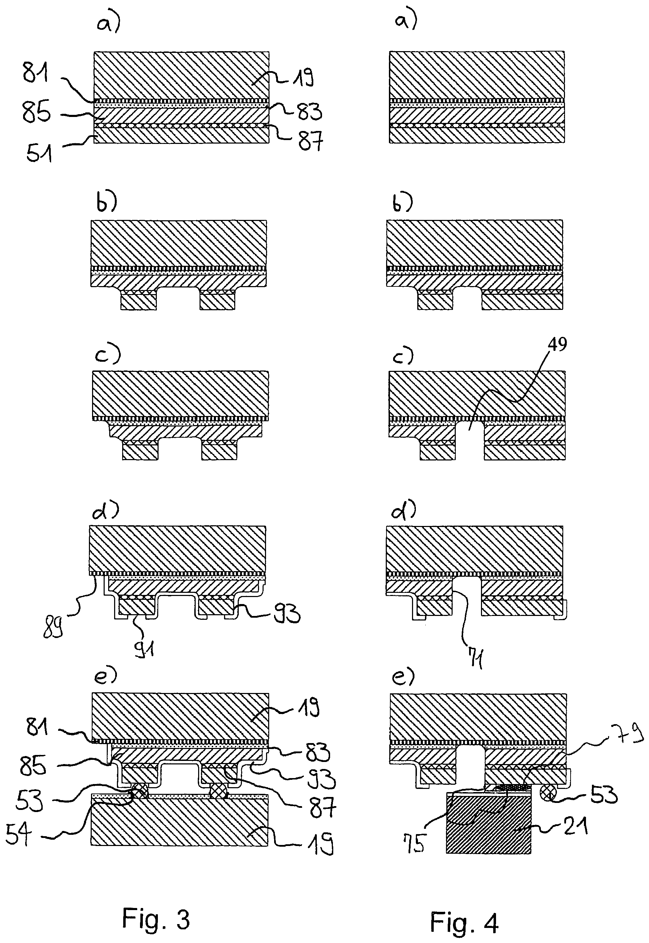

Der erfindungsgemäße Sensorkopf 11 gemäss Figur 2 umfasst das Substrat 19 mit den ersten und zweiten Sensorbereichen 29,35, die Trägerplatte 17 und eine auf der Trägerplatte 17 aufgebrachte Auswerteeinheit 47. Substrat 19, Trägerplatte 17 und Auswerteeinheit 47 sind mittels Klebstoff und Underfill mechanisch fest miteinander verbunden und gegenüber der Umgebung abgedichtet. Die Lichtquelle 21 ist vorzugsweise eine LED, die hinter einer Blende angeordnet ist, welche die Abmessung der Lichtquelle definiert. Von Bedeutung für die vorliegende Erfindung ist, dass die Sensorbereiche 29,35 in einem mehrstufigen Dünnschichtprozess direkt auf dem Substrat abgeschieden sind, durch welchen die Sensoren und die Blende 49 in vorzugsweise einem Ätzverfahren ausgebildet werden. Dieses Herstellverfahren hat den Vorteil, dass die Relation zwischen Blende 49 und Sensorbereichen 29,35 sehr präzis festgelegt werden kann, so dass diese in einer Ätzstufe gemäss Fig. 3b und Fig. 4b ausgebildet werden können.

Die elektrische Verbindung zwischen den ersten und zweiten Sensorbereichen 29,35 und der Trägerplatte 17 geschieht vorzugsweise mittels Flip-Chip-Montage. Damit die wärmeempfindlichen Sensorbereiche 29,35 während des Herstellungsprozesses nicht beschädigt werden können - was der Fall sein könnte, wenn "bumps" aus Lot eingesetzt würden - werden für die elektrische Kontaktierung sogenannte "stud bumps" oder mit Ultraschall angebrachte Goldkugeln 53 auf dem aus Aluminium gebildeten obersten Sensorbereich 51 (Fig. 3e) aufgebracht. Auf der Trägerplatte 17 wiederum sind Leiterbahnen 55 vorgesehen. Oberhalb dieser Leiterbahnen 55 wird vorzugsweise ein Film 57 angebracht, welcher an der Stelle der geplanten elektrischen Verbindung Aussparungen 59 aufweist, die vor der Montage mit Leitklebstoff 54 (fig 3e) gefüllt werden (Fig. 3e). Mittels Flip-Chip-Montage können nun Substrat 19 und Trägerplatte 17 miteinander verbunden werden. In der nicht-leitenden Schicht 57 sind an den vorgesehenen Kontaktstellen Aussparungen 59 vorhanden. Als Filmbildner eignen sich unterschiedliche Kunststoffe wie z.B. Epoxymaterial. Nach dem Verbinden wird dann der Zwischenraum zwischen Trägerplatte 17 und Glassubstrat 19 mit einem sogenannten "Underfill" ausgefüllt.

Auf der Rückseite 63 der Trägerplatte 17 ist die Auswerteschaltung 47, z.B. ein ASIC, angeordnet. Die Verbindung der Auswerteschaltung 47 mit der Trägerplatte 17 kann ebenfalls durch Flip-Chip-Montage analog der Verbindung zwischen dem Glassubstrat 19 und der Trägerplatte 17 erfolgen. Zu diesem Zweck sind auf der Rückseite 63 Leiterbahnen 64 und eine nicht-leitende Schicht 65 mit Aussparungen 67 aufgebracht. Die Aussparungen 67 stimmen dabei mit den zu kontaktierenden Punkten der Auswerteschaltung 47 überein. In diese wird vor dem Zusammenfügen der Trägerplatte 17 mit der Auswerteschaltung 47 ein elektrisch leitender Kleber eingefüllt. Die Durchkontaktierung von der Vorder- zur Rückseite erfolgt mittels Durchbrüchen 69 in der Trägerplatte 17, welche mit einem leitenden Material, z.B. einem Lot oder einem elektrisch leitenden Kleber, gefüllt sind.

Wie aus der Figur 2 hervorgeht, ist in einer Ausnehmung 71 der Trägerplatte 17 die Lichtquelle 21, z.B. eine LED, aufgenommen. Ein Distanzelement 75 hält die Lichtquelle 21 in Abstand vom Glassubstrat 19, sodass zwischen der Lichtöffnung bzw. Blende 49 ein Luftspalt 77 vorgesehen ist. Der Luftspalt 77 dient dazu, die im Substrat 19 vorhandene innere Reflexion zu reduzieren, und damit eine bessere Nutzung der Lichtenergie zu erreichen. Die Rückseite der LED-Lichtquelle 21 kann mittels eines elektrisch leitenden Klebers 79 (fig 4e) kontaktiert sein.

Von Bedeutung für die Anwendung der vorliegenden Erfindung ist insbesondere die Art der Herstellung des Sensorbereichs und der Blende 49 in Dünnschichttechnologie. Dabei werden in einem ersten Schritt alle Schichten, die für den Aufbau der Sensorbereiche nötig sind, großflächig auf ein transparentes Substrat, vorzugsweise ein Glassubstrat, abgeschieden (Fig. 3a). Die Glassubstratgröße wird so gewählt, dass eine Vielzahl von insbesondere mehr als 200, vorzugsweise mehr als 2000 und besonders bevorzugt mehr als 10'000 Sensoranordnungen gleichzeitig hergestellt werden können. Die Auswahl der Substratgröße erfolgt dabei in Abhängigkeit der vorhandenen Beschichtungs- und Ätzvorrichtungen.

Bei der Herstellung der Lichtempfänger werden auf dem Glassubstrat 19 vorzugsweise folgende Schichten nacheinander aufgebracht (Fig. 3a), was vorzugsweise den Aufbau einer PIN-Diode ergibt:
1) eine leitende transparente Schicht 81, vorzugsweise eine TCO (= Transparent Conducting Oxide) Schicht, mit einer Schichtdicke zwischen 10 und 100 nm, vorzugsweise zwischen 20 und 70 nm und besonders bevorzugt zwischen 25 und 50 nm.
2) eine erste n- oder p+ dotierte Schicht 83 mit einer Schichtdicke zwischen 10 und 80 nm, vorzugsweise zwischen 20 und 70 nm und besonders bevorzugt zwischen 25 und 50 nm.
3) eine intrinsische (intrisic) Schicht 85 mit einer Schichtdicke zwischen 100 und 1500 nm, vorzugsweise zwischen 200 und 1000 nm und besonders bevorzugt zwischen 400 und 800 nm.
4) eine zweite p+ oder n- dotierte Schicht 87 mit einer Schichtdicke zwischen 10 und 80 nm, vorzugsweise zwischen 20 und 70 nm und besonders bevorzugt zwischen 25 und 50 nm und
5) eine leitende Oberschicht 51 mit einer Schichtdicke zwischen 100 und 2000 nm, vorzugsweise zwischen 500 und 1500 nm und insbesondere zwischen 700 und 1200 nm. Im Bereich der Kontaktstellen 89,91, bzw. im Bereich der Pads 111 (vgl. Fig 10) beträgt die Schichtdicke besonders bevorzugt 1000 nm.

Die Abscheidung der verschiedenen Schichten erfolgt vorzugsweise mittels eines CVD (chemical vapor deposition), PECVD (plasma enhanced chemical vapor deposition) oder ähnlicher, abgewandelter Prozesse wie VHFCVD oder HWCWD. Bevorzugt ist eine plasmaunterstützte chemische Gasphasenabscheidung von vorzugsweise Silan, um eine aSi:h (amorphes Silizium) intrisische Schicht zu erzeugen. Für die Dotierung der Schichten werden dem Silan vorzugsweise weitere Gase zugemischt, die die Metalle Germanium (z.B. GeH) und/oder Bor (z.B. BH) enthalten.

Nachdem das Glassubstrat mit den oben genannten Schichten beschichtet ist, wird die Form und Ausdehnung der Lichtempfängerelemente und der Lichtquelle definiert, indem ein Photoresist auf die oberste Schicht 51 aufgebracht, dieser mit einer Maske mit UV belichtet wird und entweder die unbelichteten oder die belichteten Bereiche abgelöst werden. Danach kann in einem ersten Ätzschritt, beispielsweise mittels lonenstrahlätzen ("ion beam etching") an jenen Stellen, wo der Photoresist abgelöst ist, die leitende Deckschicht 51, die zweite dotierte Schicht 87 und vorzugsweise ein Teil der amorphen Siliziumschicht 85 entfernt werden. Dadurch ist die Struktur der Lichtempfänger bereits gebildet (Fig. 3b). Anstelle des amorphen Siliziums könnten auch ähnliche Materialen eingesetzt werden, die vorzugsweise für die Bildung einer PIN-diode einsetzbar sind.

Danach wird in einem weiteren Schritt an bestimmten Stellen die TCO-Schicht freigelegt, indem die amorphe Siliziumschicht 85 und die erste dotierte Schicht 83 im Wesentlichen in einem zweiten Ätzschritt (Ionenstrahlätzen und/oder "reactive Ion Beam Etching" (RIE)), oder abgewandelte Verfahren) vollständig weggeätzt werden (Fig. 3c). Die Vorgehensweise kann analog dem ersten Ätzprozess sein, d.h. die nicht zu bearbeitenden Stellen werden zuerst maskiert und dann werden die nicht-maskierten Stellen bearbeitet. Diese Verfahrensschritte sind dem Fachmann bestens bekannt, sodass an dieser Stelle nicht näher darauf eingegangen zu werden braucht. Die freigelegten Stellen bilden nach dem Entfernen der amorphen Siliziumschicht die eine elektrische Kontaktstelle 89 des Lichtempfängers. Die andere Kontaktstelle 91 ist durch die leitende Deckschicht 51 gebildet.

Anschließend wird der Sensorbereich vorzugsweise mit einer Schutzschicht 93, vorzugsweise einer SiO2 - Schicht beschichtet (Fig. 3d). Dabei werden die Kontaktstellen 89,91 jeweils durch Ätzen oder im Lift-Off - Verfahren ausgespart. Es sei noch darauf hingewiesen, dass die Figuren 3 und 4 ausschließlich der Veranschaulichung des Herstellungsprozesses dienen und dass die gezeigten Schichtdicken nicht mit den tatsächlichen Schichtdicken übereinstimmen.

Wie aus der Figur 4 hervorgeht, kann die in diesem Ausführungsbeispiel zur Ausbildung der Lichtquelle eingesetzte Blende mittels den gleichen Verfahrensschritten, wie sie für die Herstellung der Lichtempfängerstrukturen und der Kontakte verwendet werden, hergestellt werden. Dabei wird im zweiten Ätzschritt (Fig. 4c) die Lichtöffnung 49 angebracht, indem eine bereits im ersten Ätzprozess angeätzte Stelle weiter bzw. vollständig geätzt wird.
Durch diese Lichtöffnung 49 kann das Licht ungehindert in das Substrat 19 eintreten. Allfällige weitere (nicht-transparente) Schichten, wie die Al-Schicht 51 weisen an gleicher Stelle ebenfalls eine Öffnung auf, um den Lichtdurchtritt nicht zu behindern. Auf diese Weise wird eine Blende gebildet, die mit Vorteil die Ausbreitung des Lichts aus der LED 21 einschränkt, bzw. der Grösse oder die Abmessungen der Lichtquelle definiert.

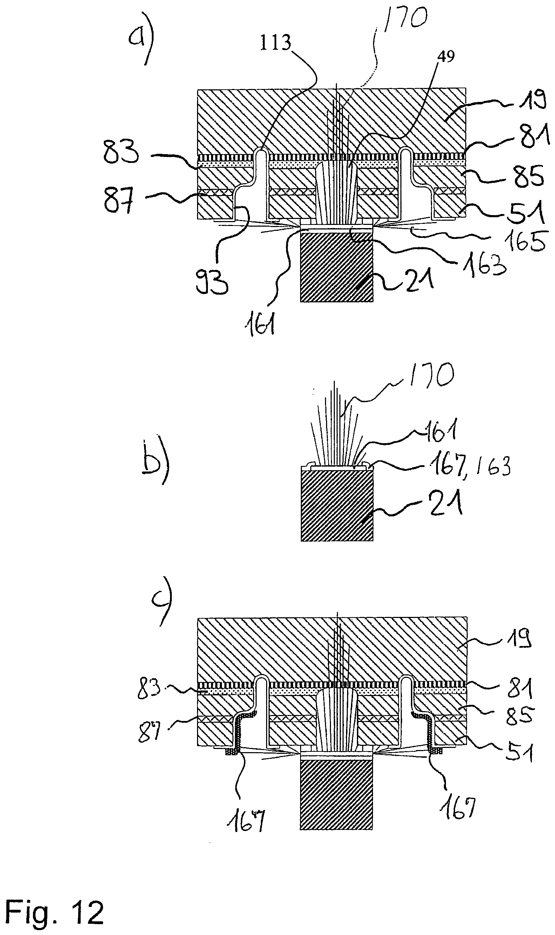

Die LED kann auf die oberste Schicht 51 aufgeklebt werden, indem sie auf einen Abstandshalter 75 aufgelegt wird (s.a. Fig. 12). Der Distanzhalter 75 sorgt für einen definierten Spalt zwischen dem Substrat 19 und der Lichtquelle 21. Damit wird (in zuverlässiger Weise) eine Kavität für den Klebstoff 79 definiert. Der Distanzhalter wird 4 bis 50 µm hoch, vorzugsweise 6 bis 12 µm hoch sein und wird vorzugsweise aus Permanentresist gebildet

Zuletzt werden die Sensorbereiche mit der Trägerplatte 17 mittels Flip-Chip-Montage miteinander elektrisch verbunden. Im gleichen Verfahrensschritt wird auch die Vorderseite der Lichtquelle mit der Metallschicht 51, in welcher nicht näher gezeigte Leiterbahnen ausgebildet sind, kontaktiert (Kontaktstelle).

Die Dicke des Glassubstrats 19 kann etwa 1 mm betragen. Bevorzugt beträgt die Dicke zwischen 0.4 und 0.6 mm, wobei für hochauflösende Encoder vorzugsweise ein Glassubstrat mit einer Dicke von etwa 0.16 mm eingesetzt werden kann.

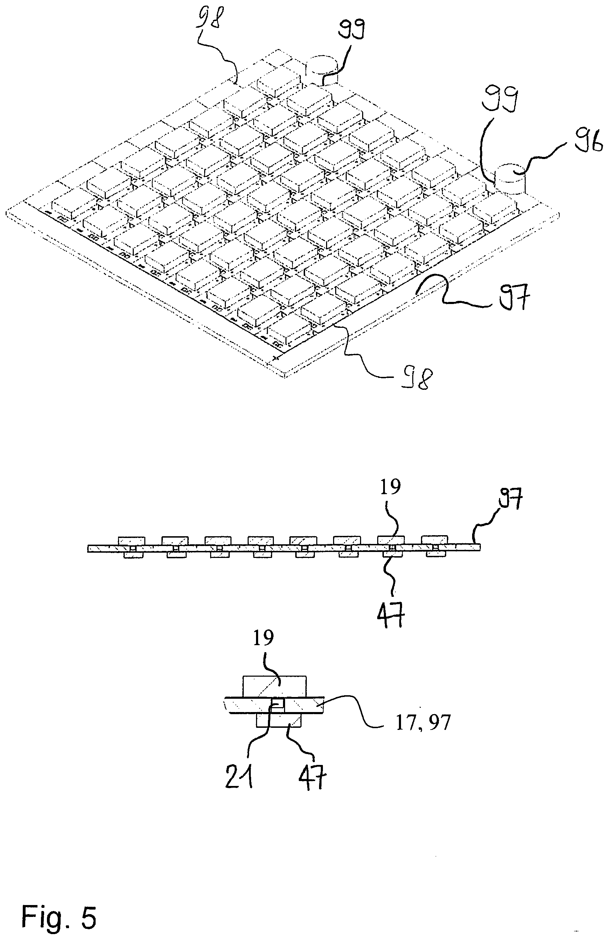

Fig. 5 zeigt eine Anordnung einer Vielzahl von nebeneinander angeordneten Sensorköpfen auf einer grossen Trägerplatte 97 in Form eines Wafers. Die Abbildung zeigt die Substrate 19, die mittels Flip-Chip-Montage auf dem Trägermaterial 97 befestigt sind. Das Trägermaterial ist eine Platte aus elektrisch nicht leitendem Material, auf welcher in einem vorgängigen Beschichtungsprozess sowohl auf der Vorder- wie auch Rückseite Leiterbahnen für die Kontaktierung einer Vielzahl von Substraten 19 mit Lichtempfängern und Auswerteschaltungen 47 aufgebracht sind. Dabei können die Lichtquellen 21 vorgängig entweder direkt, z.B. durch Kleben, auf das Glassubstrat 19 aufgebracht oder in einer Ausnehmung des Trägermaterials 97 integriert werden. Anschließend kann die Rückseite des Trägermaterials 97 mit den Auswerteschaltungen 47 bestückt werden. Die Montage der Auswerteschaltung 47 kann ebenfalls im Flip-Chip-Verfahren erfolgen. Dabei können das Substrat 19 mit den Lichtempfängerelementen 23 und die Auswerteschaltung 47 gleichzeitig mit der Trägerplatte 17 verbunden werden. Wenn die Sensorköpfe 11 bzw. die Glassubstrate 19 mit den Auswerteschaltungen 47 kontaktiert sind, kann die Encoderfunktion bereits getestet werden. Dies kann in einem automatisierten Prozess erfolgen. Erst danach wird das Trägermaterial 97,welches vorzugsweise geritzt ist (Rillen 98), in Trägerplatten 17 auseinandergebrochen, gesägt oder mittels einer Schleifscheibe getrennt. Vorzugsweise handelt es sich beim Trägermaterial um Keramik, insbesondere schwarz gefärbte Keramik.

An einer Seitenkante des Trägermaterials 97 sind zwei Einbuchtungen 99 vorgesehen, in welche Stifte 96 eines Werkzeuges eingreifen können. Mit Hilfe der Einbuchtungen 99 und entsprechenden Werkzeugen kann das Trägermaterial 97 während den diversen Prozessschritten genau ausgerichtet werden. Dies erlaubt eine kostengünstige Fertigung.

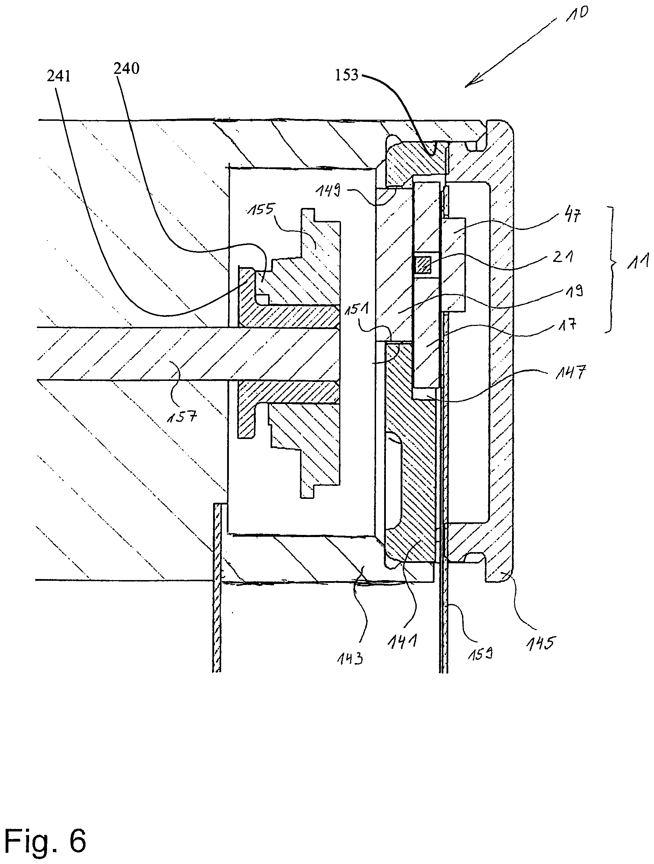

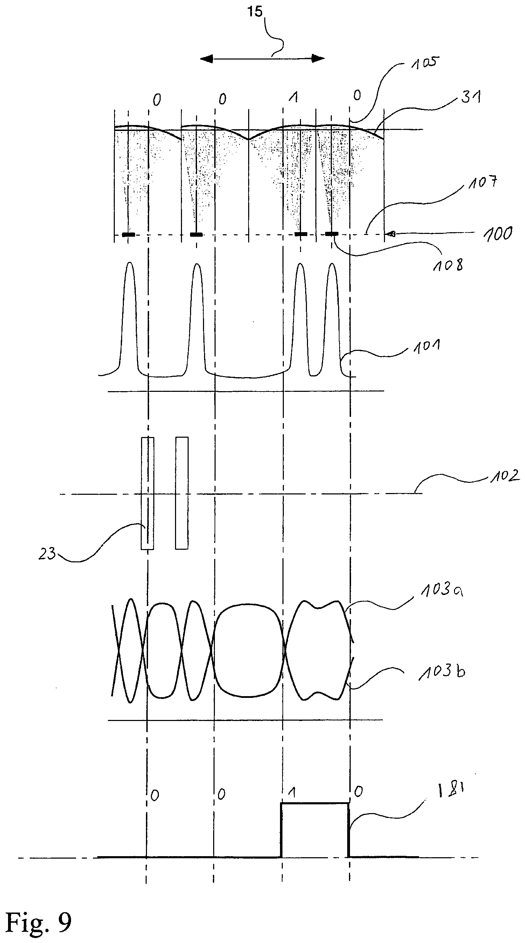

In Fig. 6 ist ein Beispiel eines Miniaturmotors gezeigt, an welchen dank der kompakten Ausführung des Sensorkopfes ein hochwertiger Sensor angebaut werden kann. Sollte auf der Maßverkörperung eine Absolutspur gemäß Fig. 9 und eine Inkrementalspur gemäss Fig. 7 vorhanden sein, lässt sich in gleichen Bauvolumen und gleicher Konstruktion ein Absolutgeber bauen. In diesem Fall braucht es eine Bewegung von weniger als etwa 2°, damit die absolute Position ermittelt oder auf der Maßverkörperung mittels des Sensorkopfes abgelesen werden kann. Mit Encodern des aktuellen Stands der Technik (mit einer Index-Marke) ist eine Winkelbewegung von bis zu 360° erforderlich, damit ein absoluter Referenzpunkt gefunden werden kann.

Fig. 6 zeigt einen Encoder 10 mit einem Sensorkopf 11 sowie einer Codescheibe 155, auf deren Oberfläche eine Massverkörperung (nicht gezeigt) angeordnet ist. Die Codescheibe 155 ist mit einer Welle 157 verbunden und dadurch drehbar. Der Sensorkopf 11 und die aus optischen Elementen (nicht gezeigt) gebildete Massverkörperung wirken zur Erzeugung eines Signals zusammen. Dazu weist der Sensorkopf 11 in dieser Ausgestaltungsform eine Lichtquelle 21 auf, welche Licht in Richtung der Massverkörperung aussendet. Die optischen Elemente der Massverkörperung sind auf der dem Sensorkopf 11 zugewandten Seite der Codescheibe 155 angeordnet. Sie werfen das von der Lichtquelle 21 kommende Licht in gebündelter Form zurück auf den Sensorkopf 11, wo es von den Lichtempfängerelementen (nicht gezeigt) registriert wird. Natürlich kann die Lichtquelle auch auf der anderen Seite der Codescheibe 155 angeordnet sein und das Licht durch die optischen Elemente zum Sensorkopf 11 senden. Die gezeigte Lösung, bei der der Sensorkopf 11 sowohl eine oder mehrere Lichtquellen als auch ein oder mehrere Lichtempfängerelemente aufweist, ist jedoch bevorzugt. Für eine korrekte Ausbildung der Positionssignale müssen die Lichtempfängerelemente in einer definierten Position relativ zu den optischen Elementen angeordnet sein. Anstatt, wie aus dem Stand der Technik bekannt, durch ein Werkzeug und/oder eine optische Vorrichtung direkt die Position der Lichtempfängerelemente relativ zur Massverkörperung oder zum Gehäuse anzupassen, wird dies beim gezeigten Encoder 10 indirekt durch eine Abstimmung der Abmessungen der einzelnen Vorrichtungsteile aufeinander erreicht. Der Sensorkopfhalter 141 weist ein erstes Strukturelement in Form einer Öffnung 149 auf, in welche ein Teil des Sensorkopfs 11, passgenau eingesetzt werden kann, wodurch sich eine formschlüssige Verbindung ergibt. Bei diesem Teil des Sensorkopfs 11 handelt es sich mit Vorteil um ein transparentes Substrat 19, auf welches die Lichtempfängerelemente vorzugsweise per Dünnschichtverfahren aufgebracht sind. Bei solchen Verfahren wird eine Vielzahl von Lichtempfängerelementen auf eine Substratplatte aufgebracht, welche anschliessend in (kleinere) Substrate 19 zerschnitten wird. Eine solche Bauform des Sensorkopfs 11 ermöglicht es, dass die Lage der Lichtempfängerelemente relativ zu den Rändern der Substrate durch das genaue Schneiden der Substratplatte bestimmt wird. Der Rand 151 des Substrats 19 kann formschlüssig mit der genannten Öffnung 149 im Sensorkopfhalter 141 zusammenwirken. Die Öffnung 149 ist relativ zu einem zweiten Strukturelement, bei welchem es sich hier um den Rand 153 des Sensorkopfhalters 141 handelt, genau positioniert. Der Rand 153 des Sensorkopfhalters 141 wirkt formschlüssig mit der Innenwand des Gehäuses 143 zusammen, wobei das Gehäuse 143 wiederum in einer definierten Position relativ zur Massverkörperung angeordnet ist. Das heisst, die Position des Sensorkopfs 11 bzw. des Substrats 19 und somit auch die Position der Lichtempfängerelemente relativ zu den optischen Elementen auf der Massverkörperung wird indirekt über mehrere, in ihren Abmessungen aufeinander abgestimmte Vorrichtungsteile festgelegt. Der Vorteil besteht darin, dass eine mechanische Justierung beim Zusammenbau entfällt. Der Sensorkopfhalter 141 wirkt also gleichsam als Adapter. In Bezug auf die genannten Abmessungen bzw. die definierten Positionen sind mit Vorteil Abweichungen von weniger als 0.2 mm, vorzugsweise weniger als 0.05 mm gewährleistet, was für eine korrekte Funktion der Messvorrichtung im Allgemeinen ausreicht. Das Gehäuse 143 ist durch einen Deckel 145 verschlossen, welcher gegen den Sensorkopfhalter 141 drückt und diesen so im Gehäuse 143 fixiert. Das Gehäuse 143 weist vorzugsweise zwischen Deckel 145 und Gehäuse 143 eine Öffnung auf, durch welche eine Kontaktierung des Sensorkopfs 11 z.B. mittels Kabel 159, vorzugsweise mittels eines Flexprints, erfolgen kann. Durch diese Anordnung wird eine einfache Montage des Sensorkopfes gewährleistet. Gemäss der in Fig. 6 dargestellten bevorzugten Ausgestaltungvariante eines Encoders 10 ist an der Welle 157 ein Adapter für die Codescheibe 155 vorgesehen. Der Adapter weist eine Aufnahme für die Welle sowie einen sich von der Welle 157 radial nach aussen erstreckenden Flansch 241 auf. Bevorzugt besitzt der Adapter eine hohlzylindrische Wellenaufnahme sowie einen ringförmigen, sich von der Wellenaufnahme abhebenden Flansch 241. Die Codescheibe 155 steht mit der von der Welle 157 abgewandten Seite der Wellenaufnahme sowie mit dem Flansch 241 des Adapters in Kontakt, wobei es bevorzugt ist, wenn die Codescheibe ein oder mehrere Füsse 240 besitzt, die im zusammengebauten Zustand des Encoders 10 mit dem Flansch 241 in Kontakt treten. Die Befestigung der Codescheibe 155 am Adapter erfolgt bevorzugt mittels Klebstoff. Durch diese Anordnung wird eine einfache Montage des Sensorkopfes gewährleistet.

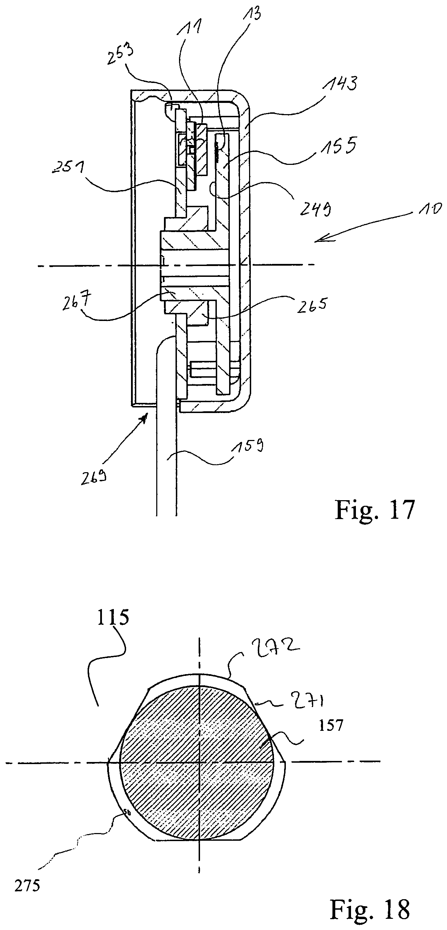

Die Codescheibe 155 wird auf die Welle 157 vorzugsweise aufgeklebt. Das Durchgangsloch 272 der Codescheibe ist vorzugsweise so gestaltet (vgl Fig 18), dass ein oder mehrere Kanäle 275 (z.B. 2-20 oder 3-10 Stück) zwischen der Codescheibe und der Welle 157 ausgebildet werden, in denen der Klebstoff Platz findet. Fig. 18 zeigt eine Ausführung des Durchgangslochs 272 einer Codescheibe 155, wobei die Codescheibe über flache Bereiche 271 formschlüssig mit der Welle 157 verbunden ist. Entsprechend sind diejenigen Teile der Ränder des Durchgangslochs 272, welche die Kanäle 275 bilden, weiter (insbesondere um 0,02 bis 0,2 mm weiter) von der Welle entfernt, als die diejenigen Teile der Ränder, die die flachen Bereiche 271 bilden. Letztere stehen vorzugsweise in Kontakt mit der Welle, d.h. die flachen Bereiche stellen die Kontaktstellen zwischen Codescheibe 155 und Welle 157 dar. Die Kanäle 275 zwischen Codescheibe und Welle 157 können mit Klebstoff gefüllt werden. Diese Anordnung ist insbesondere vorteilhaft aus der Sicht des Werkzeugmachers, da sie es ihm erlaubt sehr einfach ein Werkzeug für das Anbringen eines Durchgangslochs 272 herzustellen. Das genannte Werkzeug wird mit Vorteil aus einem (vorzugsweise kreiszylindrischen) Werkstück gefertigt, welches einen Durchmesser aufweist, der um 0.02 bis 0.2 mm grösser ist, als der Durchmesser der Welle 157. Das Werkstück kann dann an mehreren Stellen z.B. durch Abschleifen mit Abflachungen bzw. flachen Seiten versehen werden, welche bei der Herstellung des Durchgangslochs 272 die flachen Bereiche 271 bilden. Nach einer bevorzugten Ausgestaltungsvariante sind 1 bis 10, insbesondere 2 bis 5 und besonders bevorzugt 3 Kanäle 275 vorgesehen.

Die Codescheibe und die Massverkörperung werden bevorzugt aus Kunststoff, vorzugsweise für eine erleichterte Sichtkontrolle schwarz eingefärbtem Kunststoff, ausgebildet. Die Massverkörperung wird dann mit einem Metall, vorzugsweise mit Gold- oder Aluminium beschichtet. Auf der Aluminium-Schicht kann allerdings eine zusätzliche Schutzschicht, wie z.B. SiO2 oder Kunstharz, aufgetragen werden.

Eine alternative Ausführung sieht einen Folienaufbau der Codescheibe vor. Als Trägermaterial kann ein Kunststoff dienen, auf welchem eine Aluminiumschicht und eine Kunststofffolie als Oxydationsschutz der Aluminiumschicht vorgesehen sind. Die Massverkörperung kann mittel Heissprägen auf der Seite der Aluminium-Schicht ausgebildet werden.

Die Figuren 7, 8 und 9 zeigen verschiedene Ausführungsformen von Maßverkörperungen 25/31 und Lichtempfängerelementen 23, die zur Ausbildung mindestens eines Analogsignals 103 dienen. Die Analogsignale 103a und 103b werden in einer Auswerteschaltung verarbeitet und gegebenenfalls in ein weiterverarbeitbares Digitalsignal 104 umgewandelt. Die von der Auswerteschaltung herausgegebenen Signale dienen zur Bestimmung der Position der Maßverkörperung relativ zum Sensorkopf. Die Auswertung der Positionsdaten kann mit Hilfe eines Analog- oder Digitalsignals erfolgen.

Fig. 7 zeigt eine inkrementelle Spur, Fig. 8 die Spur für die Bildung eines Indexes, der zumindest einmal pro Umdrehung ausgewertet wird, Fig. 9 zeigt einen weiteren Spuraufbau, der nach dem Manchester-Code kodiert ist, welcher zusammen mit dem inkrementalen Signal eine Absolutposition definieren kann. Die drei erwähnten Spuren können allein oder in Kombination die Maßverkörperung bilden, die auf einem Träger, wie zum Beispiel einer Codescheibe, integriert sein kann und vorzugsweise im gleichen Arbeitsgang wie der Träger gefertigt wird. Die Maßverkörperung wird vorzugsweise mit zwei Spuren ausgebildet, wobei die optischen Elemente beider Spuren vorzugsweise die gleiche Brennweite aufweisen.

Die in Fig. 7 dargestellte Spur 25 der Maßverkörperung besteht aus identischen optischen Elementen, die in Bewegungsrichtung 15 in regelmäßigen Abständen voneinander angeordnet sind (Inkrementalspur). Diese sind gleich oder parallel in Bezug auf die Hauptrichtung des von ihnen zurückgeworfenen Lichts ausgerichtet. In der Figur 7 sind die optischen Elemente halbkreiszylindrische Reflektoren, welche die bevorzugte Ausführungsform im Rahmen der vorliegenden Erfindung darstellen. Das von der Lichtquelle ausgesandte Licht wird durch ein optisches Element der Maßverkörperung gebündelt und auf die Sensorebene 100 fokussiert. Dort trifft das Licht in einem Punkt 108 auf. Der benachbarte Bereiche 107 der Sensorebene wird hingegen nicht oder nur mit wenig Licht beaufschlagt. Die Verteilung der Lichtintensität auf der Sensorebene wird durch die Kurve 101 dargestellt. Der Punkt 101h der Kurve entspricht einer hohen Energiedichte, der Punkt 101t einer niedrigen Energiedichte. Die elektrische Umwandlung der Lichtintensität in ein elektrisches Signal erfolgt mit zumindest zwei Lichtempfängerelementen 23, welche vorzugsweise um 180° versetzt zueinander angeordnet sind. Dies bedeutet, dass immer dann, wenn das eine Lichtempfängerelement ein Maximum registriert, das andere Lichtempfängerelement ein Minimum registriert, und umgekehrt. Mit den beiden Lichtempfängerelementen werden zwei Analogsignale 103A+ und 103A- erzeugt, welche an die Auswerteschaltung zur Weiterverarbeitung weitergeleitet werden. Die Auswerteschaltung kann aus den Analogsignalen103 sodann ein Digitalsignal 104 bilden.

Fig. 8 zeigt die Indexspur 31 einer Massverkörperung bestehend aus einem einzelnen, im Schnitt ungefähr halbkreiszylindrischen Reflektor, der um die Achsen 105 zentriert ist. Die Breite dieses Reflektors wird zwischen 100% und 300% der Breite eines Reflektors der Inkrementalspur sein. Auf der Sensorebene 100 wird das Licht im Wesentlichen in einem Punkt 108 gebündelt, wobei der angrenzende Bereich 107 nur mit wenig Licht beaufschlagt wird. Der restliche Bereich 109 wird mit einer im Wesentlichen konstanten und unmodulierten Lichtmenge beaufschlagt. Die Verteilung der Lichtintensität auf der Sensorebene 100 ist durch die Kurve 101 dargestellt, wobei der Punkt 101h einer hohen Energiedichte und der Punkt 101t einer niedrigen Energiedichte entspricht. Die Umwandlung der Lichtintensität in ein elektrisches Signal erfolgt vorzugsweise mit einer speziellen Anordnung von Lichtempfängerelementen 23. Gemäss einer bevorzugten Ausführungsform bestehen die Lichtempfängerelemente 23, aus einem Hauptempfänger 23Z+ und zwei Empfängern 23Z-, welche symmetrisch zum Hauptempfänger 23Z+ angeordnet und elektrisch miteinander verbunden sind. Vorteilhafterweise ist die Gesamtfläche der Lichtempfänger 23Z- um wenigstens 10 %, vorzugsweise wenigstens 20% und besonders bevorzugt wenigstens 30% größer als die Gesamtfläche des Hauptempfängers 23Z+. Dies ist von Bedeutung im Zusammenhang mit der Auswertung der Signale. Dadurch, dass die Flächeninhalte der beiden Lichtempfängerelemente Z+/Z- sich unterscheiden, kann sichergestellt werden, dass das Signal 103a vom Signal 103b deutlich beabstandet ist, sodass diese sich im restlichen Bereich 109 keinesfalls kreuzen können. Mit dieser Lichtempfängeranordnung werden zwei Analogsignale 103a und 103b erzeugt, die in der Auswerteschaltung weiterverarbeitet werden. Dabei können die Signale z.B. in einer Komparatorschaltung verglichen werden, wobei ein Kreuzungspunkt der beiden Signale jeweils eine Veränderung des Digitalpegels. d.h. eine der Flanken des Impulses Zb (vgl. Digitalsignal 104) erzeugt.

Für die Bildung eines stabilen digitalen Pulses 104 ist es von Bedeutung, dass die beiden Signale 103a und 103b sich mit einer großen Steigung kreuzen. Dies wird durch die spezielle Anordnung der Lichtempfängerelemente 23 erreicht: In der zentralen Stellung gemäss Figur 8 trifft der gebündelte Lichtstrahl hauptsächlich auf das mittlere Empfängerelement 23Z+, wodurch der Signalpeak 103aa gebildet wird. Damit der Signalpegel 103ba so tief wie möglich ist, sollen die beiden Lichtempfänger Z- beispielsweise im Punkt 107 weniger Licht als normal, d.h. als wenn der Lichtstrahl nicht moduliert ist, empfangen. Dies wird dadurch erreicht, dass die schräg liegenden Lichtempfängerelemente am oberen Teil, d.h. am proximalen Ende, etwas breiter als am distalen Ende ausgebildet sind. Die gezeigte Ausgestaltung der Empfänger 23Z+,23Z- mit einem ersten länglichen Lichtempfängerelement 23Z+ und zwei zweiten länglichen Lichtempfängerelementen 23Z-, die im Wesentlichen spiegelbildsymmetrisch und in einem Winkel zur Längsachse des ersten Empfängerelements 23Z+ angeordnet sind, kann als optimal angesehen werden. Mit dieser Gestalt der Lichtempfängerelemente können Signale 103a und 103b gebildet werden, die in den gegenseitigen Kreuzungspunkten eine große Steigung aufweisen, sodass ein zuverlässiges Grundsignal Zb für das Indexsignal gebildet werden kann.

Die Lichtemfägerelemente Z- ("Z minus") sind gegenüber dem Lichtempfängerelement Z+ ("Z plus") schräg angeordnet. An ihren vom Lichtempfängerelement Z+ abgewandten Enden weisen die Lichtempfängerelemente Zeine Breite auf, die viel kleiner ist als die Breite an ihren dem Lichtempfängerelement Z+ zugewandten Enden. Diese optimale Anordnung hat damit zu tun, dass während der Bewegung der Indexlinse (optisches Element auf der Massverkörperung) in die Richtung 15, Bereiche mittlerer, niedriger und hoher Lichtintensität über den Sensorbereich bewegt werden. Die Gestalt der Lichtempfängerelemente Z- ermöglicht es, das sich die Veränderung der Lichtintensität nicht in jeder Position der Indexlinse relativ zum Sensorbereich gleich stark auf das Signal auswirkt. Im Randbereich, d.h. dort, wo das schmale Ende des Lichtempfängerelements Z- detektiert, wirkt sich die Lichtintensität weniger stark auf das Signal aus, als im zentralen Bereich, d.h. am Ort des Lichtempfängerelements Z+ und dort wo das breitere Ende des Lichtempfängerelements Z- ist. Ein weiterer Faktor ist der Abstand zur Lichtquelle. Die schmalen Enden der Lichtempfängerelemente Z- sind weiter von der Lichtquelle entfernt und erhalten dadurch eine geringere Lichtintensität.

Vorzugsweise fällt der geometrische Schwerpunkt 102b der beiden Lichtempfängerelemente 23Z+ und 23Z-möglichst im gleichen Punkt zusammen. Fallen die Schwerpunkte nicht zusammen, d.h. sind diese voneinander beabstandet, dann verändert sich das Pegelverhältnis zwischen den beiden Signalen 103a und 103b, wenn der Abstand zwischen der Maßverkörperung 13 und dem Substrat 19 sich verändert (s. Fig. 1). Dank der beschriebenen, vorteilhaften geometrischen Ausbildung der Empfängerelemente 23 kann der Abstand zwischen Maßverkörperung und Sensorkopf in einem relativ großen Bereich variieren, ohne dass die Signalqualität darunter leiden würde, wodurch die eher große Toleranz bei der axialen Lage von Wellen bei Kleinmotoren problemlos aufgenommen werden kann. Dies hat auch den Vorteil, dass aufwändige Justierarbeiten nicht erforderlich sind.

Fig. 9 zeigt eine Spur 31 der Massverkörperung (Absolutspur). Die Spur enthält wie die in Fig.7 gezeigte Inkrementalspur eine Vielzahl von optischen Elementen, wobei die optischen Elemente hier aber nicht alle gleich oder regelmässig bzw. (in Bezug auf ihre optische Achse) nicht alle parallel ausgerichtet sind. Jedes der optischen Elemente ist so ausgestaltet und/oder angeordnet, dass es das Licht entweder auf einen ersten oder einen zweiten Punkt auf der Sensorebene fokussiert. Die beiden Punkte repräsentieren die 0 (Null) bzw. die 1 (Eins) eines Binärcodes. Die Abfolge der Nullen und Einsen (Binärziffern) definiert einen Code, z.B. einen 8-Bit-Code, bei dem 8 aufeinander folgende Binärziffern eine charakteristische Positionszahl definieren, die vorzugsweise nur ein einziges Mal auf der Massverkörperung bzw. über die Länge der Massvörkörperung vorkommt. Im vorliegenden Beispiel liegt der eine Punkt links von der Achse 105 und der andere rechts davon. Es ist aber auch möglich drei oder mehr verschiedene Punkte vorzusehen, d.h. die optischen Elemente entsprechend anzuordnen und/oder auszugestalten, dass durch die Abfolge der unterschiedlich positionierten Auftreffpunkte 108 auf der Sensorebene 100 z.B. ein ternärer Code entsteht. Bevorzugt ist jedoch ein binärer Code, insbesondere ein sogenannter Manchester-Code. Auf der Sensorebene 100 wird das Licht in einem Punkt 108 gebündelt, der jeweils asymmetrisch zur Achse 105 angeordnet ist. Nur wenig Licht fällt dabei auf den Bereich 107. Die Verteilung der Lichtintensität auf der Sensorebene ist durch die Kurve 101 dargestellt. Die elektrische Umwandlung der Lichtintensität in ein elektrisches Signal erfolgt vorzugsweise mit zumindest zwei um 180 Grad zueinander versetzt angeordneten Lichtempfängerelementen 23. Mit den Lichtempfängerelementen 23, werden zwei Analogsignale 103a und 103b erzeugt, die zusammen mit einem Inkrementalsignal an eine Auswerteschaltung geliefert werden. Die Auswerteschaltung wird mit Hilfe des Inkrementalsignals die Signale 103 so auswerten, dass der Bitwert der Teilung bestimmt wird und in einem Digitalsignal ausgegeben wird.

Mit Vorteil sind zwei Kanäle (A und B) und pro Kanal zwei Lichtempfängerelemente 23 wie oben beschrieben vorgesehen. Es ist anzumerken, dass in den Fig.7 und 9 der Übersichtlichkeit wegen jeweils nur die Lichtempfängerelemente 23 für einen Kanal (A oder B) gezeigt sind.

Das Lesen des Bitwerts erfolgt für eine gegebene Bewegungs- bzw. Drehrichtung der Massverkörperung nach15 bei jeder ansteigenden oder jeder abfallenden Flanke der beiden Inkrementalsignale, vorzugsweise bei jeder vierten Flanke der beiden Inkrementalsignals (aus den Kanälen A und/oder B), indem in diesem Zeitpunkt der Unterschied zwischen Signal 103a und 103b abgelesen wird. Zu diesem Zeitpunkt wird der Pegel des Digitalsignals 181 dem Bitwert entsprechend eingestellt oder der Bitwert wird auf eine andere Art ausgegeben. Es kann auch vorgesehen sein, dass das Lesen des Bitwertes in eine Drehrichtung oder Bewegungsrichtung der Massverkörperung zum Beispiel bei abfallender Flanke des Kanals A ausgeführt wird und bei Drehung oder Bewegung der in die Gegenrichtung bei ansteigender Flanke des Kanals A.

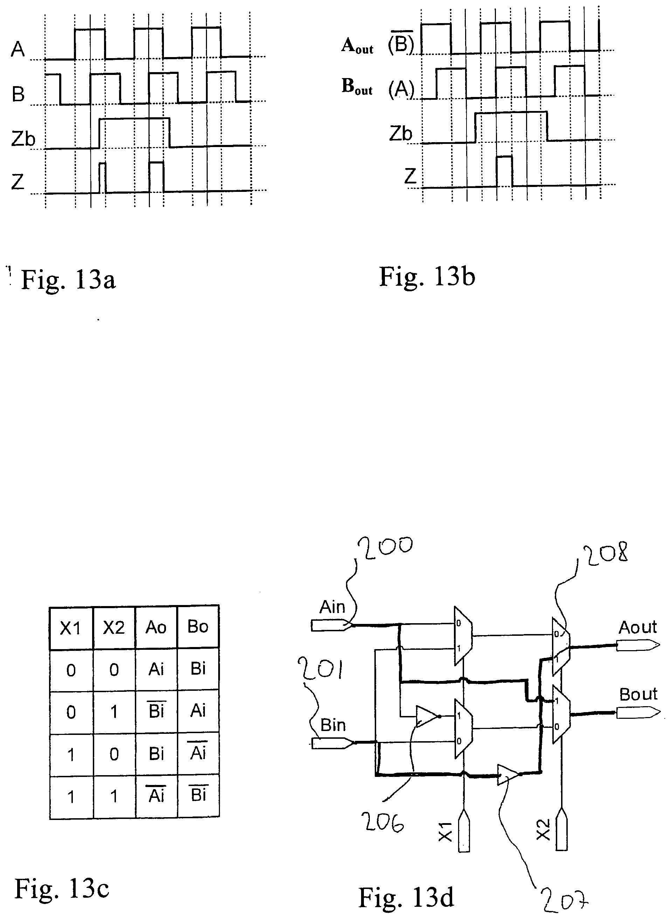

Die beiden Inkrementalsignals bilden pro Teilung 4 Flanken (zwei Analogsignale 103a/103b pro Kanal A/B). Welche von diesen Flanken für die Auswertung des Bitwertes eingesetzt wird, hängt letztlich von der Platzierung des Sensorkopfes innerhalb des zulässigen Toleranzfeldes in Bezug auf eine Verdrehung um den Winkel 41 (vgl. Fig 1) ab. Die Korrektur des Winkelfehlers kann mit der in Fig. 13 dargestellte Schaltung erfolgen.

Wie oben erwähnt, wird die Reihenfolge der Bitwerte der Maßverkörperung so gewählt, dass bei einer bestimmten Anzahl von aufeinander folgenden Bits eine bestimmte Reihenfolge nur ein Mal über die Länge der Massverkörperung zu finden ist. Die Reihenfolge wird vorzugsweise gemäss Manchester-Code gebildet.

Fig 10 zeigt eine Anordnung der Lichtempfängerelemente 23 für einen 3-Kanal Encoder (Kanal A, Kanal B, Kanal Z oder Index), wobei die durch das Zentrum der Lichtquelle verlaufende Hauptachse 45 des ausgesandten Lichtstrahls sich mit der Mittellinie 43 der Maßverkörperung (Fig 1, 2) deckt (s. Fig. 1). Im Sensorbereich 29 (welcher mit der ersten Spur 25 der Massverkörperung zusammenwirkt) sind die Lichtempfängerelemente für das Inkrementalsignal und im Sensorbereich 35 (welcher mit der zweiten Spur 31 der Massverkörperung zusammenwirkt) diejenigen für das Indexsignal angeordnet. An den Kontaktstelle bzw. Öffnungen 91 (siehe auch Fig. 3d und 3e) können die "Stud-Bumps" auf der obersten Metallschicht (vgl. 51 in Fig. 3a) z.B. durch Ultraschallschweissen angeordnet werden. Diese Stellen können mit einer Goldschicht abgedeckt werden, damit bei Verwendung eines leitenden Klebers die Klebewirkung nicht durch eine Oxidschicht beeinträchtigt wird. Der gleiche Sensorkopf könnte ebenfalls für einen Absolut-Encoder mit Manchchester-Code eingesetzt werden, wobei dann der Bereich 25 unverändert bleibt und im Bereich 31 zumindest zwei Empfängerelemente (wie z.B. in Fig.9 gezeigt) angeordnet sind.

Damit der Encoder unempfindlich gegenüber Montagetoleranzen ist (d.h. in Bezug auf die Zentrierung der Lichtquelle und die Winkelstellung des Sensorkopfes bezüglich der Hauptachse 43 (vgl. Fig. 1) der Massverkörperung, wird vorzugsweise in Bezug auf die Bewegungsrichtung 15 folgende Reihenfolge der Lichtempfängerelemente gewählt: A+/B-/A-/B+ oder A-/B+/A+/B- , d.h. eine in Bezug auf die beiden Kanäle A und B symmetrische Anordnung der Lichtempfängerelemente bezüglich der Achse 39. Dabei sind die Lichtempfängerelemente A+,A- und B-,B+ jeweils um 180 Grad versetzt zueinander angeordnet. Auf diese Weise werden sowohl für den Kanal A als auch für den Kanal B zwei um 180 Grad versetzt zueinander angeordnete, sinusförmige Kurven erhalten, die in einer Komparatorschaltung in ein Digitalsignal umgewandet werden können. In dieser Anordnung werden die Kontaktstellen und die Verknüpfung zwischen den Lichtempfängerelementen 23 im gleichen bzw. aus demselben Material wie die Lichtempfängerelemente gebildet, d.h. dass diese Bereiche ebenfalls optoelektronisch aktiv sind. Es ist dann darauf zu achten, dass der Schwerpunkt jedes der 4 Lichtempfängerelemente im Sensorbereich 29 im Wesentlichen den gleichen Abstand von der Lichtquelle 21 hat (siehe Linie 102). Hier markieren die Punkte 102b jeweils den Schwerpunkt eines U-förmigen Empfängerelements. In Richtung 15 sollen dabei die Abstände zwischen den Schwerpunkten 102b mit der Teilung der Maßverkörperung im Wesentlichen übereinstimmen. Die normale Breite 114 eines Lichtempfängers im Sensorbereich 29 wird vorzugsweise zwischen 40 und 80% der Breite einer Teilung der Maßverkörperung gewählt. Unter Breite soll in diesem Zusammenhang jene Dimension der Lichtempfängerelemente oder der Lichtquelle verstanden werden, welche parallel zur Hauptachse 45-verläuft. Um den Schwerpunkt eines Arrays von Lichtempfängerelementen am richtigen Ort zu erhalten, ist es meist notwendig, die Breite der Empfängerelemente an gewissen Stellen 106 breiter zu machen, bzw. in der breite anpassen. Der Grund ist, dass die Übergangsleitungen 115 innerhalb der Lichtempfängerelemente und die Flächen um die Kontaktstellen bzw. Öffnungen 91 ebenfalls Licht detektieren, d.h. die Flächen der Lichtempfängerelemente zwangsweise vergrössern. Dies beeinflusst die Lage der Schwerpunkte 102b der Lichtempfängerelemente und das erzeugte Signal auf eine negative Weise. Die Bezugsziffer 110 zeigt die Kontakte zur TCO-Schicht.

Vorteilhafterweise wird die Breite der Lichtquelle 21 resp. der Blende 49 zwischen 60 und 150 % vorzugsweise 100% bis 120% der Breite einer Teilung gewähft. Ist die Breite der Blende 49 zu klein, wird zu wenig Lichtenergie durchgelassen. Ist die Breite der Blende 49 zu gross, dann wird die Breite des Lichtspots zu groß, sodass die Signale zu flach werden, um zuverlässig ausgewertet zu werden.

Eine gleiche Anordnung der Lichtquelle und der optischen Empfängerelemente könnte mit anderen Technologien verwirklich werden, wenn z.B. die Lichtquelle 21 als eine Licht emittierende OLED auf das Substrat 19 aufgebaut würde, und die Sensorbereiche 35 und 29 einen ähnlichen Schichtaufbau wie die OLED hätten. Sowohl OLED wie auch die Lichtempfängerelemente bestehen dann aus dünnen Schichten, vorzugsweise wie gezeigt in Fig. 3a, wobei jedoch unterschiedliche Ausgangsmaterialen zum Einsatz kommen können.

Fig. 11 zeigt eine andere Anordnung von Lichtempfängerelementen, wobei die einzelnen Empfängerelemente über VIAs 112 ("vertical interconnect access") durch die Passivationsschicht (z.B. eine SiO2-Schicht oder ein SiO2/Si3N4 Schichtaufbau) mit auf der Passivationsschicht angelegten leitenden Bahnen, vorzugsweise aus Aluminium, elektrisch verbunden sind. Der Vorteil dieser Anordnung liegt darin, dass die Lichtempfängerelemente 23 optimal gestaltet werden, ohne dass die Übergangsleitungen 115 und/oder Kontaktstellen 91 die Bildung der Analogsignale beeinflussen können, bzw. ohne das Korrekturen an der Breite 114 vorgenommen wird. Am Ende der leitenden Bahnen liegen die Pads 111 worauf die "Stud-Bumps" angebracht werden. Insofern wird so eine Lösung mehr kosten, da zusätzliche Schichten vorgesehen und zusätzliche Vorkehrungen getroffen werden müssen. Eine Anordnung der Empfängerelemente 23 in der Bewegungsrichtung 15 hat die gleichen Vorteile, wie sie schon bei der Beschreibung der Fig. 10 angegeben wurden. Die Verbindung zur TCO-Schicht kann auch mittels der leitenden Bahnen und eines VIA 112 erfolgen, wobei am Ende der leitenden Bahnen wiederum Pads 111 angehordnet sein können zum sicheren Anbringen eines Stud-Bumps.

In Fig. 12 ist eine bevorzugte Ausbildung der Lichtquelle bestehend aus Blende und LED gezeigt (s. a. Fig. 2). Die LED wird wie in Fig. 4c beschrieben auf das Substrat 19 (vorzugsweise aus Glas), bzw. auf der oberste Metallschicht (vgl. Fig. 3, 51), aufgeklebt und strahlt durch die Lichtöffnung 49, die in dem Dünnschichtaufbau ausgespart ist. Die LED 21 ist in der Ausnehmung 71 (vgl. Fig. 2) der Trägerplatte 17 (vgl. Fig. 2) aufgenommen. Es sind verschiedene Varianten gezeigt, wie die Lichtquelle am Substrat 19 montiert werden kann. Fig. 12a zeigt die Lichtquelle mit einer Emissionsschicht 161 und einer Kontaktschicht 163. Zwischen der Lichtquelle 21 und dem beschichteten Glassubstrat 19 ist ein Abstandhalter 75 vorgesehen, welcher die Lichtquelle in Abstand zum Substrat 19 hält. Es ist erkennbar, dass bei dieser Konstruktion die Gefahr besteht, dass seitlich austretendes Licht 165 auf den Lichtempfänger fällt, d.h. diese Anordnung ist nachteilig, weil das erzeugte Streulicht in den Lichtsensorbereich eindringen kann, was zu Abweichungen von der angestrebten Signalqualität führen kann. Die Bezugsziffer 170 zeigt den von der Lichtquelle ausgesandte Lichtkegel in Richtung zur Massverkörperung.

Fig. 12b zeigt eine isolierte Lichtquelle, bei welcher die Emissionsschicht 161 am Rand mit einer nicht transparenten Deckschicht 167 beschichtet ist. Damit kann verhindert werden, dass Streulicht auf den Lichtempfänger fällt. Gemäß Fig. 12c ist die nicht transparente Deckschicht 167 nicht auf die Lichtquelle 21 sondern auf dem Lichtempfänger aufgebracht. Diese Deckschicht dient im Beispiel auch als Kontakt 163 zur LED. Weitere Vorkehrungen können darin bestehen, dass als "Underfill" ein Material gewählt wird, welches lichtundurchlässig ist oder eine geringe Transmission für Licht hat.

Fig. 13 zeigt eine Schaltung, mit welcher Montagefehler bezüglich der Winkelstellung 41 (vgl. Fig 1) des Sensorkopfes in Bezug auf die Hauptachse der Maßverkörperung kompensiert werden kann, damit das Indexsignal unabhängig von so einem Winkelfehler zuverlässig funktionieren kann. Wie oben beschrieben, hängt die Wahl der Flanke des Inkrementalsignals für die Bestimmung des Bitwertes (im Zusammenhang mit einer Absolutspur) von der Platzierung des Sensorkopfes bzw. von der Verdrehung desselben um den Winkel 41 ab. Die Schaltung kann somit zur Bestimmung dieser Flanken eingesetzt werden.

Fig. 13a zeigt die Signale A, B, Zb und Z. Signal Z wird aus der Kombination der Signale A und B und Zb gebildet. A und B entsprechen jeweils einem Digitalsignal 181 (vgl. Fig.9; nur Signal für einen Kanal gezeigt), wobei Signal A aus Kanal A und Signal B aus Kanal B stammt. Das in dieser Fig. 13a abgebildete Signal Z besteht aus zwei Impulsen, was grundsätzlich nicht erwünscht ist. Durch eine Rekombination der ursprünglichen Signale A und B werden in Fig. 13b andere Signalzustände Aout (bzw. Ao) und Bout (bzw. Bo) erzeugt, wobei das Signal Zb beinahe zentrisch zum Bereich der Signale A und B im Plus ist. Das resultierende Signal Z besteht folglich aus einem einzigen Puls.

Die Umwandlung (Rekombination) der ursprünglichen Signale A (bzw. Ain) und B (Bin) in die effektiven Ausgangsignalen Aout und Bout erfolgt mithilfe der Steuersignale X1 und X2, zB. gemäss der Kombinationstabelle in Fig 13c, wobei die ursprünglichen Signale A und B invertiert und/oder gegeneinander vertauscht werden.

Die beiden Kanäle A und B der Fig. 13b bestehen für den Kanal A aus dem invertierten Eingangskanal B und für den Kanal B aus dem Eingangskanal A. Somit bildet die Kombination der Signale aus Kanal Aout und Kanal Bout und Kanal Zb ein Indexsignal Z mit einem einzigen Puls. Weitere Signalkombinationen sind in der Wahrheitstabelle 13c dargestellt.

Die Signalverarbeitung nach der Wahrheitstabelle kann durch die abgebildete Schaltung (Fig. 13d) erfolgen. Die Schaltung wird durch zwei Steuersignale X1 und X2 angesteuert. Die Signale Ain 200 und Bin 201 werden durch zwei Inverter 206,207 invertiert. Die Schaltung enthält zusätzlich 4 Mutliplexer 208, die je nach Zustand der Steuersignale X1,X2 das eine der zwei Signale im Eingang an den jeweiligen Ausgang weiterleiten. Bei den in Fig. 13a und 13b angeführten Beispielen sind die Steuersignale auf X1=0 und X2=1 gestellt, wobei die Schaltwege mit dickeren Linie in der Fig. 13d eingetragen sind. Die Steuersignale X1 und X2 werden in der Auswerteschaltung erzeugt. Die Auswerteschaltung ist so ausgebildet, dass diverse Einstellungen bzw. Werte für die Steuersignale einprogrammiert werden können, was bei der Endkontrolle des Produkts erfolgen kann.

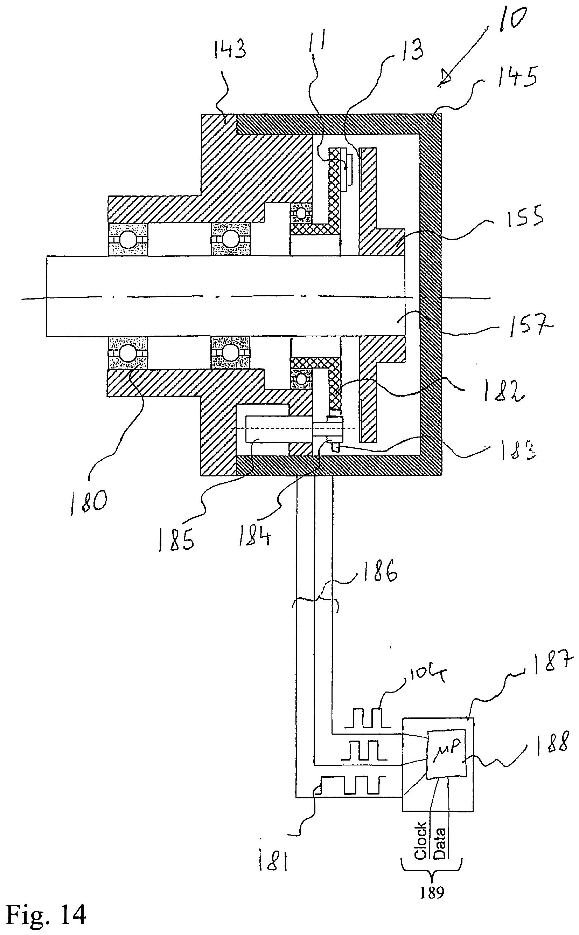

In Fig. 14 wird ein spezieller Aufbau eines Absolutencoders schematisch dargestellt, der auch bei still liegendem Sensorkopf 11 oder still liegender Welle 157, bzw. im Kaltstart, ein absolutes Positionssignal ermitteln kann. Dies wird durch eine spezielle Vorrichtung ermöglicht, welche eine relative Bewegung zwischen Massverkörperung und Sensorkopf erlaubt. Die Vorrichtung besitzt einen Schwenkarm 182 (oder eine äquivalente Einrichtung), auf welchem der zumindest eine Sensorkopf befestigt ist. Der Schwenkarm wird mit einem Motor angetrieben, und erzeugt eine Relativbewegung zwischen Massverkörperung 13 und Sensorkopf 11, die einem Bruchteil, vorzugsweise weniger als 5 Grad, einer ganzen Umdrehung entspricht. Durch Auswertung der aus dem Sensorkopf 11 kommenden Signale kann die absolute Position ermittelt werden. Dies wird wiederum dank der kompakten Bauweise des Sensorkopfes und der toleranzfreundlichen Bauweise dieser Anordnung möglich.

Fig. 14 zeigt den schematischen Aufbau des Absolutencoders mit einem Gehäuse 143,145, einer gelagerten Welle 157, einer Codescheibe 155 mit einer Maßverkörperung 13 mit vorzugsweise einer Absolutspur nach Fig. 9 und einer Inkrementalspur nach Fig. 7, einem fixen oder um einen kleinen Winkel schwenkbaren Träger 182, auf welchem zumindest ein Sensorkopf 11 angebracht ist. Die Codescheibe 155 ist auf einer Welle 157 zentrisch befestigt, welche Welle in einem Gehäuse 143 mit zumindest einem Lager 180 formschlüssig zusammenwirkt.

Durch eine kleine Bewegung der Achse bzw. eine Bewegung der Codescheibe von vorzugsweise weniger als 3 Grad kann eine Positionszahl ermittelt werden, womit ein (absoluter) Positionswert der Codescheibe ermittelt werden kann. Danach kann die Ermittlung des Positionswerts entweder durch Ab-/Aufzählung (Addition / Subtraktion) der Pulse aus der Inkrementalspur oder durch Ermittlung von weiteren Positionszahlen bestimmt werden. Eine redundante Erfassung der Positionswerte kann durch Kombination beider Varianten leicht realisiert werden.

Vorzugsweise wird der Manchester-Code mit einem oder mehreren Paaren von Empfängerelementen gelesen (s. Fig. 9). Eine Positionszahl wird zwischen 1 und einer maximalen Anzahl von Positionszahlen durch eine Bewegung der Massverkörperung in Relation zum Sensorkopf ermittelt. Die Länge der Positionszahl, in binärer Form ausgedrückt, ist die Anzahl von Bits, welche durch die Länge der Massverkörperung bestimmt ist. Die Positionszahl wird durch Lesen einer Anzahl von aufeinanderfolgenden Bits ermittelt Eine Positionszahl ist durch die nach dem Manchestercode ausgebildete Massverköperung definiert. Auf die ganze Länge der Massverkörperung sind die Positionszahlen singulär, d.h. bestimmen jeweils die Lage der Massverkörperung relativ zu den Lichtempfängern. Die Umwandlung der gelesenen Positionszahl in einen Positionswert erfolgt mit der Auswerteschaltung. Die Positionszahl wird vorzugsweise mittels Digitalsignal 181 übertragen und durch eine Umwandlungsschaltung 187 in einen Positionswert umgewandelt. Die Umwandlungsschaltung 187 kann in der Auswerteschaltung 47 (s.a. Fig.2) integriert sein.

Eine redundante Ermittlung der Positionswerte kann gegen Lesefehler absichern, indem mehrere aufeinander folgende Positionszahlen registriert werden. Dies bedeutet, dass eigentlich eine "verlängerte" Positionszahl aufgenommen wird. Die verlängerte Positionszahl wird in mehrere Positionswerte umgewandelt. Sollten die Positionswerte nicht in einer Reihe anordenbar sein, dann würde dies auf einen Lesefehler des Manschestercodes schliessen lassen.

In der Fig. 14 ist eine Anordnung gezeigt, bei der die Umwandlungsschaltung 187 ausserhalb des Sensors angeordnet ist. Die Umwandlungsschaltung 187 ist mit 3 Leitungen 186 mit dem Encoder, bzw dessen Auswerteschaltung, verbunden (schematische Darstellung). Zwei Leitungen übertragen die Impulse aus den Kanälen A und B (Digitalsignal 104) und die dritte Leitung ein Digitalsignal 181, das die Positionszahlen der Absolutspur abbildet. Somit werden Positionsinformation in redundanter Weise zwischen Encoder 10 und Umwandlungsschaltung 187 übertragen. Damit wird eine sichere Übertragung der Positionszahlen und Ermittlung der Positionswerte gewährleistet. Die Umwandlungschlatung 187 übergibt mittels eines herkömmlichen Datenbusses 189, wie z.B. SPI, I2C, Profibus etc., die Daten beispielsweise weiter zu einer SPS Steuerung. Die Umwandlungsschaltung 187 umfasst vorzugsweise einen Mikroprozessor 188, der die Übersetzung der Positionszahlen in Positionswerte vornimmt. Die Übersetzung der Positionszahl in einen Positionswert kann auf zweierlei Arten erfolgen:
a) ein Manchestercode-Generator bildet nacheinander Positionszahlen; wenn eine der zu übersetzenden Positionszahlen aus der Massverkörperung mit der generierten Positionszahl übereinstimmt, wird die Positionszahl des Generators als Positionswert ausgegeben,
b) im Mikroprozessor ist eine Tabelle vorgesehen, die Positionswerte enthält, wobei jeder Speicherort in der Tabelle bzw. jeder Positionswert mit einer bestimmten Positionszahl assoziiert ist, wodurch Positionszahlen bestimmten Positionswerten zugeordnet werden können.

Ein Nachteil herkömmlicher Encodersysteme mit Manchester-Code liegt darin, dass für die Bestimmung der Absolutposition eine relative Bewegung der Maßverkörperung, und damit eine Bewegung der zu messenden Maschinenteile notwendig ist, um die absoluten Positionswerte zu ermitteln. Dies wird vom Maschinenbauer nicht geschätzt.

Es ist erwünscht, dass ein Positionswert beim Einschalten der Maschinen noch bevor irgendwelche Bewegungen stattfinden, ermittelbar ist. Dies wird dadurch gelöst, dass die Codescheibe eine grosse Anzahl von Spuren aufweist, wobei jeder Spur mindestens je ein Empfängerelement zugeordnet ist. Die dafür notwendige Schaltung ist komplex und der Platzbedarf für solch eine vielspurige Anordnung ist gross, wodurch Positionsmessvorrichtungen dieser Art nicht in kleine Gehäuse passen.

Eine weitere Ausführungsform der Erfindung besteht deshalb darin, dass Mittel vorgesehen sind, die eine Bewegung des Sensorkopfes relativ zur Maßverkörperung intern im Sensor ermöglichen, so dass auf Knopfdruck eine Ermittlung der Positionswertes möglich wird, ohne dass die Maschine in Bewegung gesetzt werden muss. Dies wird erreicht, indem der der Sensorkopf bzw. der Träger (z.B. ein Schwenkarm 182) auf welchem der Sensorkopf angeordnet ist, um ca. 3° verdreht wird. Dies kann beispielsweise mit einem Motor 185 und einem Exzenter 184 erfolgen, der vorzugsweise formschlüssig in einen Schlitz 183 des Schwenkarms 182 eingreift. Anstelle eines Motors mit hebel und excenter kann Aktoren unterschiedlicher Art einegesetzt werden. Die durch diese Bewegung erzeugten Signale (Kanal A, Kanal B und M-Code) können dann zur Ermittlung der Positionswerte verwendet werden.

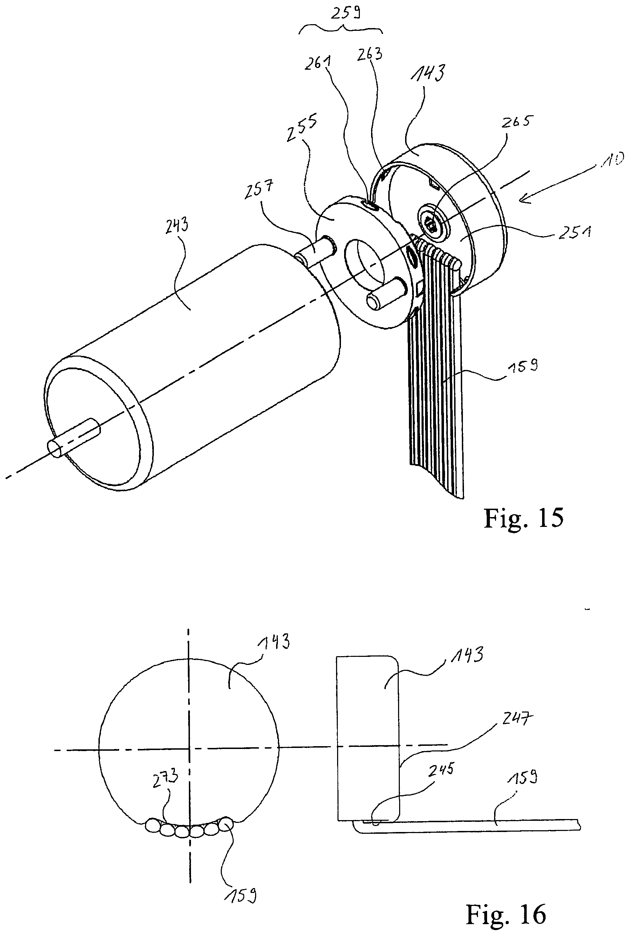

Die Fig. 15 bis 17 zeigen eine Positionsmessvorrichtung. Es handelt sich hier um einen Kit Encoder 10. welcher eine besonders kompakte Bauform aufweist. Diese Bauform ist charakterisiert durch eine bestimmte Anordnung der Codescheibe 155, der darauf angebrachten Massverkörperung 13, des Gehäuses 143 und des Sensorkopfs 11, welcher mit der Massverkörperung 13 zur Erzeugung eines Signals zusammenwirkt. Die Massverkörperung 13 befindet sich hier auf derjenigen Seite 249 der Codescheibe 155, welche vom Gehäuse 143 abgewandt ist. Gemeint ist hier bevorzugt ein neben, entlang oder im Wesentlichen parallel zu der flachen Seite der Codescheibe 155 verlaufender Teil des Gehäuses 143 und/oder der obere Teil des Gehäuses 143. Vorzugsweise ist also die Codescheibe 155 zwischen der Innenseite des Gehäuses 143 (oder der Innenseite des genannten Teils des Gehäuses) und dem Sensorkopf 11 oder der Leiterplatte 251 angeordnet. Aus der Tatsache, dass die Aufnahme 267 für die Welle (oder zumindest der grössere Teil, insbesondere mindestens 70 oder 90% der Länge der Wellenaufnahme) auf derselben Seite der Codescheibe 155 angeordnet ist, wie die Massverkörperung 13, ergibt sich eine wesentliche Platzersparnis. Der Grund dafür ist, dass der Ort der Messung, also der Bereich zwischen Massverkörperung 13 und Sensorkopf 11 neben der Welle bzw. der Wellenaufnahme 267 angeordnet ist. Bei der Montage der Codescheibe 155 im Gehäuse 143 kann die Position der Codescheibe 155 relativ zum oben genannten, dazu parallelen Teil des Gehäuses 143 bzw. der Abstand zwischen der Innenseite des Gehäuses 143 und der Codescheibe 155 festgelegt werden, indem der genannte parallele Teil des Gehäuses 143 eingedrückt bzw. deformiert wird und nach dem Einbau der Codescheibe 155 wieder entspannt wird. Um dies zu vereinfachen, kann das Material des Gehäuses 143 am genannten Teil, der parallel zur Codescheibe 155 verläuft, dünner oder elastischer sein als bei daran angrenzenden Teilen. Mit Vorteil ist der Sensorkopf 11 auf eine Leiterplatte 251 montiert, welche formschlüssig mit dem Gehäuse 143 zusammenwirkt. Die Leiterplatte 251 kann konstruktiv auch die Funktion der Trägerplatte übernehmen.

Besonders bevorzugt geschieht dies über eine Schnappverbindung 153. Eine sehr einfache Montage des Encoders 10 kann durch den Einsatz eines Adapterteils 255 bewerkstelligt werden, welches ein erstes Verbindungsmittel 257 und ein zweites Verbindungsmittel 259 aufweist. Das erste Verbindungsmittel 257 dient bevorzugt dazu, das Adapterteil 255 in Bezug auf die Welle zentrisch am Motor 243 zu befestigen und kann beispielsweise aus Schrauben bestehen. Beim zweiten Verbindungsmittel 259 handelt es sich mit Vorteil um eine Schnappverbindung 259, welche z.B. durch ein oder mehrere Vorsprünge 261 und ein oder mehrere Vertiefungen 263 gebildet wird. Vorsprünge 261 und Vertiefungen 263 können am Gehäuse (insbesondere an der Gehäuseinnenwand) und/oder am Adapterteil 255 angeordnet sein. Vorzugsweise handelt es sich um eine lösbare Verbindung. Vorteilhafterweise besitzt das Gehäuse 143 ein Montagelager 265, in welches die Codescheibe 155 und/oder eine mit der Codescheibe 155 verbundene Aufnahme 267 für eine Welle aufgenommen sein. Letzteres deshalb, weil die Codescheibe 155 und die Wellenaufnahme 267 entweder einstückig ausgebildet sein können, was bevorzugt ist, oder eben miteinander verbundene Einzelteile darstellen können. Das Montagelager 265 hat die Funktion, die Codescheibe während des Montagevorgangs zentrisch zum Gehäuse zu halten. Das Lager selbst kann ein Kugellager oder ein Gleitlager aus Teflon sein, wobei Letzteres bevorzugt ist, da durch ein solches Lager die Rotation der Motorwelle nicht belastet wird.

Die Funktion des Montagelagers besteht darin, eine genaue Fluchtung der Codescheibe und des Sensorkopfs zu gewährleisten (vgl. Achse 22 in Fig 1). Das Lagermaterial Teflon hat den Vorteil einer niedrigen Reibungszahl und eines besonders ausgeprägten Kriechverhaltens, wodurch die Lagerfunktion im Montagezustand mit der Zeit verloren geht. Dies ist insofern gewünscht, als das Montagelager nach der Montage seine Lagerfunktion verlieren soll, damit das bestehende Lagersystem keine zusätzliche nachteilige Belastung erfährt. Es kann auch ein starres Lager (z.B. Kugellager) eingesetzt werden, das aber mit Vorteil elastisch mit der Leiterplatte 251 verbunden ist.

Der Radius der Codescheibe 155 ist vorzugsweise kleiner als der Radius der Leiterplatte 251. Wenn der äussere Rand des Sensorkopfs 11 in Bezug auf die Drehachse der Codescheibe 155 weiter aussen liegt als der äussere Rand der Codescheibe 155, so kann die Codescheibe 155 kleiner gestaltet werden und es verbleibt Platz z.B. für die unten genannten Kabel bzw. die Einbuchtung 273. Beim erfindungsgemässen Encoder 10 sind vorzugsweise das Gehäuse 143 und/oder die Leiterplatte 251 und/oder die Codescheibe 155 und/oder die Verbindungsmittel 253 und/oder 259 aus Kunststoff gefertigt. Eine besonders kompakte Bauform wird darüber hinaus erreicht, wenn die Kontaktierung des Sensorkopfs 11 über eine seitliche Öffnung 269 im Gehäuse 143 erfolgt. Diese Öffnung 269 ist mit Vorteil auf der von der Codescheibe 155 abgewandten Seite des Sensorkopfs 11 und/oder der Leiterplatte 251 angeordnet. Die Kontaktierung kann so auf der Unterseite des Sensorkopfs 11 oder - wenn der Sensorkopf 11 über die Leiterplatte 251 kontaktiert ist - auf der Unterseite der Leiterplatte 251 erfolgen. Die genannte Kontaktierung kann über ein oder mehrere Kabel 159 bewerkstelligt werden, welche durch die Öffnung 269 ins Gehäuse 143 gelangen. Dabei handelt es sich mit Vorzug um ein Flachkabel 159 wie es in den Figuren gezeigt wird, wobei auch ein Flexprint eingesetzt werden kann. Die Öffnung 269 weist deshalb mit Vorteil eine längliche Form auf und ist bevorzugt im Wesentlichen parallel zur Codescheibe 155 und/oder zur Leiterplatte 251 angeordnet. Das Flachkabel 159 ist ebenfalls entsprechend ausgerichtet. Wenn das Gehäuse 143 auf einer Seite 245 eine Einbuchtung 273 aufweist, welche sich an die Öffnung anschliesst, ist dies besonders vorteilhaft. Insbesondere dann, wenn die Einbuchtung von der Öffnung entlang der Seite 245 des Gehäuses 143 bis zu einer anderen Seite 247 oder bis zu einem Rand des Gehäuses 143 oder bis zu einer Kante des Gehäuses 143 verläuft. Die Einbuchtung 273 kann von der Öffnung 269 z.B. bis zur Oberseite 245 des Gehäuses 143 verlaufen. Das Kabel 159 kann so in der Einbuchtung 273 positioniert sein. Wenn das Gehäuse 143 - was bevorzugt ist - eine zylindrische Form aufweist, liegt das Kabel 159 so bevorzugt innerhalb des Zylinderradius. Weiterhin ist es von Vorteil, wenn die Positionsmessvorrichtung, bzw. der Encoder 10 eines oder mehrere der Merkmale aufweist, wie sie in anderen Teilen dieses Dokuments beschrieben sind. Insbesondere die Ausgestaltung des Sensorkopfs 11 und der Massverkörperung seien genannt. Die Massverkörperung weist beispielsweise bevorzugt mindestens zwei Spuren auf, wobei es sich bei einer Spur um eine Inkrementalspur handelt und wobei es sich bei einer zweiten Spur vorzugsweise entweder um eine Indexspur oder eine codierte Spur handelt, wie sie in diesem Dokument beschrieben werden.

Die in Fig.17 gezeigten Teile bilden zusammen eine Vorrichtungskomponente, die vor der Auslieferung werkseitig kontrolliert bzw. getestet werden kann. Zusammen mit dem Verbindungsmittel 255 (vgl. Fig.15) bildet die genannte Vorrichtungskomponente ein Assembly-Kit, das ohne besonderen Aufwand zum Beispiel an einem Motor angebracht werden kann.

Die Fig 18. zeigt eine vorteilhafte Verbindungstechnik zur Befestigung einer Codescheibe 155 an einer Welle157. Die Codescheibe weist ein Durchgangsloch 272 mit einer speziellen Form auf, beispielsweise eine zylindrische Form mit vorzugsweise 3 (oder mehr) flachen bzw. abgeflachten Bereichen 271. Die Codescheibe wird auf die Welle 157 zentrisch angeordnet, durch Einführen der Welle 157 in das Durchgangsloch 272. Die Montage einer Konststoffcodescheibe auf einer Metallwelle ist nicht so einfach, wenn man die Anforderungen in Bezug auf Rundlauftoleranzen und Presssitz betrachtet. Zu starker Presssitz kann zum Brechen der aus Kunststoff hergestellten Codescheibe führen. Dies kann auch erst nach einer gewissen Zeitperiode, das heisst zum Beispiel mehreren Monaten nach der Montage geschehen. Die Rundlauftoleranz beeinträchtigt direkt die Qualität der Encoderfunktion. Diese Anordnung ist insbesondere für den Werkzeugmacher vorteilhaft. Somit kann er die Zentrierung der Teile durch Flachschleifen am Werkzeugstempel genauestens justieren. Die Freiräume bzw. Kanäle 275 bieten Platz für Klebstoff, der in Kombination mit einem sehr leichten Presssitz das Risiko von Rissen vermeiden kann und eine sichere Verbindung beider Teile gewährleistet.

### Legende:

- 10: Encoder
- 11: Sensorkopf
- 13: Maßverkörperung
- 15: Bewegungsrichtung der Massverkörperung relativ zum Sensorkopf
- 17: Trägerplatte
- 19: Substrat
- 21: Lichtquelle
- 22: Hauptachse des ausgesandten Lichtstrahls
- 23: Lichtempfängerelemente
- 25: erste Spur der Maßverkörperung
- 27: erste optische Elemente
- 29: erster Sensorbereich
- 31: Zweite Spur der Maßverkörperung
- 33: zweites optisches Element
- 35: zweiter Sensorbereich
- 37: Flachseiten des Substrats
- 39: Längsmittelachse
- 40: Abstand Massverkörperung / Lichtsensor
- 41: Pfeil
- 43: Mittellinie der Maßverkörperung
- 45: Achse durch die Lichtquelle
- 47: Auswerteschaltung
- 49: Blende / Lichtöffnung
- 51: Metallschicht auf Sensoren
- 53: Lotkugeln
- 54: Leitender Klebstoff
- 55: Leiterbahnen auf Trägerplatte
- 57: nicht leitende Schicht (Permanentresist)
- 59: Aussparungen
- 61: Underfill
- 63: Rückseite der Trägerplatte
- 64: Leiterbahnen auf der Rückseite der Trägerplatte
- 65: nicht-leitende Schicht
- 67: Aussparungen
- 69: Durchbrüche in der Trägerplatte
- 71: Ausnehmung für Lichtquelle
- 73: Halter
- 75: Distanzhalter
- 77: Luftspalt
- 79: Kleber
- 81: leitende transparente Schicht
- 83: Erste dotierte Schicht
- 85: amorphe Siliziumschicht
- 87: zweite dotierte Schicht
- 89,91: Kontaktstellen des Lichtempfängers
- 93: Schutzschicht
- 95: Kontaktstelle zw. Lichtquelle und Schicht 51
- 96: Stift eines Werkzeugs

- 97: Trägermaterial

- 99: Einbuchtungen
- 100: Sensorebene
- 101: Kurve der Lichtintensität (h / t)
- 102: Linie, auf der die Schwerpunkte der Lichtempfängerelemente angeordnet sind
- 102b: Schwerpunkt der Lichtempfängerelemente
- 103a, 103b: Analogsignale (A+ / A- / a / aa / ab / ac / b / ba / bb)
- 104: Digitalsignal
- 105: Achse des optischen Elements
- 106: Diode
- 107: Benachbarter Bereich zu 108
- 108: Auftreffpunkt des Lichts auf 100
- 109: Restlicher Bereich (d.h. ohne Bereiche 107 und 108)
- 110: Kontaktstelle zu TCO
- 111: Pads
- 112: VIA (Vertical Interconnect Access)
- 113: Graben im Glassubstrat
- 114: Breite der Lichtempfänger
- 115: Übergangsleitungen zwischen Lichtempfängern
- 141: Sensorkopfhalter
- 143: Gehäuse
- 145: Deckel
- 147: Vertiefung
- 149: Öffnung
- 151: Rand des Substrats / Rand des Sensorkopfs
- 153: Rand des Sensorkopfhalters
- 155: Codescheibe
- 157: Welle
- 159: Kabel
- 161: Emissionsschicht der Lichtquell
- 163: Kontaktschicht
- 165: seitlich austretendes Licht
- 167: Deckschicht
- 170: Lichtkegel
- 181: Positionszahl (Digitalsignal)
- 182: Träger / Schwenkarm
- 183: Schlitz
- 184: Exzenter
- 185: Motor
- 186: Verbindungslinie
- 187: Auswerteschaltung
- 188: Mikroprozessor
- 189: Datenbuss
- 240: Fuss
- 241: Flansch
- 243: Motor
- 245: Seite des Gehäuses
- 247: Seite des Gehäuses
- 249: Vom Gehäuse abgewandte Seite der Codescheibe
- 251: Leiterplatte
- 255: Verbindungsmittel
- 257: Verbindungsmittel
- 261: Vorsprünge
- 263: Vertiefungen
- 265: Montagelager
- 267: Aufnahme für Welle
- 269: Seitliche Öffnung im Gehäuse
- 271: Flache Bereiche
- 272: Durchgangsloch (mit Kontaktstellen zwischen Codescheibe und Welle)
- 273: Einbuchtung
- 275: Kanal

## Patentansprüche

1. Positionsmessvorrichtung mit
- mindestens einer Maßverkörperung mit einer optischen Struktur,
- wenigstens einem im Abstand von der Maßverkörperung angeordneten Lichtempfänger,
- einer im Abstand von der Maßverkörperung und im Abstand vom Lichtempfänger angeordneten Lichtquelle, und
- mindestens einem zwischen der Maßverkörperung und dem Lichtempfänger vorhandenen transparenten Substrat, wobei der Lichtempfänger auf der der Maßverkörperung abgewandten Seite des Substrats in Gestalt eines Dünnschichtaufbaus bestehend aus mehreren übereinander angeordneten Schichten direkt auf das transparente Substrat abgeschieden ist,
wobei eine Trägerplatte mit Leiterbahnen vorgesehen ist, auf welcher das Substrat angeordnet ist, und das transparente Substrat und die Trägerplatte durch Flip-Chip Montage fest miteinander verbunden sind,
wobei die optische Struktur der Maßverkörperung zwei oder mehr Spuren mit optischen Elementen aufweist, und eine erste Spur der Erzeugung eines inkrementalen Signals dient,
**dadurch gekennzeichnet,**
- **dass** die optische Struktur der Maßverkörperung fokussierende optische Elemente, vorzugsweise eine Anordnung von 3-D Reflektoren, aufweist,
- **dass** der Lichtempfänger als Sensorbereich ausgebildet ist, bestehend jeweils aus einer Mehrzahl von Lichtempfängerelementen, wobei wenigstens ein erster und ein zweiter Sensorbereich vorgesehen sind, wobei der erste Sensorbereich dazu ausgebildet ist, zur Erzeugung eines inkrementalen Signals mit der ersten Spur zusammenzuwirken und wobei der zweite Sensorbereich dazu ausgebildet ist, mit einer zweiten Spur zusammenzuwirken, bei der es sich entweder um eine Indexspur oder eine codierte Spur handelt,
- **dass** der erste Sensorbereich des Lichtempfängers aus zumindest zwei Lichtempfängerelementen besteht, die vorzugsweise um 180° versetzt angeordnet sind, und
**dass** der zweite Sensorbereich des Lichtempfängers aus einem ersten länglichen Lichtempfängerelemente gebildet ist und aus zwei länglichen Lichtempfängerelementen, die im Wesentlichen spiegelsymmetrisch und in einem Winkel zur Längsachse des ersten Lichtempfängerelementes angeordnet sind.

2. Positionsmessvorrichtung nach Anspruch 1, **dadurch gekennzeichnet, dass** die Trägerplatte auf beiden Flachseiten Leiterbahnen aufweist für die Kontaktierung mit dem Lichtempfänger und für die Kontaktierung mit einer Auswerteschaltung, wobei die Auswerteschaltung vorzugsweise auf der Trägerplatte angeordnet ist.

3. Positionsmessvorrichtung nach Anspruch 2, **dadurch gekennzeichnet, dass** die Auswerteschaltung auf der vom Substrat abgewandten Seite der Trägerplatte im Flip-Chip-Verfahren angeordnet ist, wobei die Auswerteschaltung eine integrierte Schaltung zur Verarbeitung der Lichtempfängersignale ist und wobei die Lichtempfänger mit der integrierten Schaltung elektrisch verbunden sind.

4. Positionsmessvorrichtung einem der Ansprüche 1 bis 3, **dadurch gekennzeichnet, dass** die Trägerplatte eine Ausnehmung aufweist, in welche die Lichtquelle aufgenommen ist.

5. Positionsmessvorrichtung nach einem der Ansprüche 1 bis 4, **dadurch gekennzeichnet, dass** der Lichtempfänger mit einer leitenden Deckschicht kontaktiert ist und eine elektrische Verbindung zwischen der leitenden Deckschicht und den Leiterbahnen der Trägerplatte hergestellt ist, vorzugsweise mittels Kugeln, sogenannten "Bumps" oder "stud bumps".

6. Positionsmessvorrichtung nach Anspruch 5, **dadurch gekennzeichnet, dass** die Verbindung zwischen der leitenden Deckschicht oder den Kugeln einerseits und der Trägerplatte andererseits mittels eines elektrisch leitenden Klebstoffs hergestellt ist.

7. Positionsmessvorrichtung nach Anspruch 6, **dadurch gekennzeichnet, dass** zwischen der Trägerplatte und dem Substrat ein Permanentresist zur Begrenzung der Ausdehnung des Klebstoffs vorgesehen ist.

8. Positionsmessvorrichtung nach einem der Ansprüche 1 bis 7, **dadurch gekennzeichnet, dass** ein Teil der vorhandenen Zwischenräume zwischen dem transparenten Substrat und der Trägerplatte mit einem Underfill ausgefüllt ist, wobei der Underfill vorzugsweise im Wesentlichen lichtundurchlässig ist.

9. Positionsmessvorrichtung nach einem der Ansprüche 1 bis 8, **dadurch gekennzeichnet, dass** ein Luftspalt im Lichtgang zwischen Lichtquelle und Substrat vorhanden ist.

10. Positionsmessvorrichtung nach einem der Ansprüche 6 oder 7, **dadurch gekennzeichnet, dass** die Lichtquelle, vorzugsweise eine LED, auf der obersten Schicht des Dünnschichtaufbaus befestigt ist, wobei zwischen der Lichtquelle und der obersten Schicht des Dünnschichtaufbaus ein Distanzhalter vorgesehen ist, der einen definierten Spalt für den Klebstoff bildet.

11. Positionsmessvorrichtung nach einem der Ansprüche 1 bis 3 oder 5 bis 8, **dadurch gekennzeichnet, dass** die Lichtquelle, vorzugsweise eine OLED, direkt auf dem Substrat zwischen den Lichtempfängern ausgebildet ist.

12. Positionsmessvorrichtung nach einem der Ansprüche 1 bis 11, **dadurch gekennzeichnet, dass** die Trägerplatte aus Keramik besteht.

## Claims

1. Position measuring device with
- at least one material measure with an optical structure,
- at least one light receiver arranged at a distance from the material measure,
- a light source arranged at a distance from the material measure and at a distance from the light receiver, and
- at least one transparent substrate present between the material measure and the light receiver, wherein the light receiver is deposited directly on the transparent substrate, on the side of the substrate opposite the material measure in the form of a thin-film structure consisting of several layers arranged one above another,
wherein a supporting plate is provided with circuit-board conductors, on which the substrate is arranged, and the transparent substrate and the supporting plate are joined solidly together by Flip-Chip assembly,
wherein the optical structure of the material measure has two or more tracks with optical elements, and a first track serves for production of an incremental signal,
**characterised in that**,
- the optical structure of the material measure comprises focussing optical elements, preferably an arrangement of 3-D reflectors,
- the light receiver is formed as sensor zone, consisting in each case of a plurality of light receiver elements, wherein at least one first and one second sensor zones are provided, wherein the first sensor zone is designed to interact with the first track for production of an incremental signal and wherein the second sensor zone is designed to interact with a second track, which is either an index track or a coded track,
- the first sensor zone of the light receiver comprise at least two light receiver elements arranged mutually displaced by 180 degrees, and
- the second sensor zone of the light receiver is composed of a first oblong light receiver element and two oblong light receiver elements, which are arranged essentially with mirror-image symmetry and at an angle to the longitudinal axis of the first receiver element.

2. Position measuring device according to claim 1, **characterised in that** the carrier plate has circuit-board conductors on both faces for contacting with the light receiver and for contacting with a decoding circuit, wherein the decoding circuit is preferably arranged on the carrier plate.

3. Position measuring device according to claim 2, **characterised in that** the decoding circuit is arranged on the side of the carrier plate opposite the substrate in the Flip-Chip process, wherein the decoding circuit is an integrated circuit for processing the light receiver signals and wherein the light receivers are connected electrically to the integrated circuit.

4. Position measuring device according to one of claims 1 to 3, **characterised in that** the carrier plate has a recess, in which the light source is housed.

5. Position measuring device according to one of claims 1 to 4, **characterised in that** the light receiver is contacted with a conducting top layer and an electrical connection is made between the conducting top layer and the circuit-board conductors of the carrier plate, preferably by means of spheres, so-called "bumps" or "stud bumps".

6. Position measuring device according to claim 5, **characterised in that** the connection between the conducting top layer or the spheres on the one hand and the carrier plate on the other hand is made by means of an electrically conducting adhesive.

7. Position measuring device according to claim 6, **characterised in that** a permanent resist is provided between the carrier plate and the substrate in order to limit the spread of the adhesive.

8. Position measuring device according to one of claims 1 to 7, **characterised in that** a proportion of the spaces present between the transparent substrate and the carrier plate is filled with an underfill, wherein the underfill is preferably substantially opaque.

9. Position measuring device according to one of claims 1 to 8, **characterised in that** an air gap is present in the light path between light source and substrate.

10. Position measuring device according to one of claims 6 or 7, **characterised in that** the light source, preferably an LED, is fastened on the uppermost layer of the thin-film structure, wherein a spacer is provided between the light source and the uppermost layer of the thin-film structure, which forms a defined gap for the adhesive.

11. Position measuring device according to one of claims 1 to 3 or 5 to 8, **characterised in that** the light source, preferably an OLED, is formed directly on the substrate between the light receivers.

12. Position measuring device according to one of claims 1 to 11, **characterised in that** the carrier plate consists of ceramic.

## Revendications

1. Dispositif de mesure de position avec
- au moins un étalon avec une structure optique,
- au moins un récepteur de lumière placé espacé de l'étalon,
- une source de lumière placée espacée de l'étalon et espacée du récepteur de lumière et
- au moins un substrat transparent existant entre l'étalon et le récepteur de lumière, le récepteur de lumière étant déposé directement sur le substrat transparent sur le côté du substrat opposé à l'étalon en forme d'empilement de couches minces constitué par plusieurs couches superposées,
une plaque de support avec des pistes conductrices étant prévue sur laquelle le substrat est placé et le substrat transparent et la plaque de support étant reliés de manière fixe par un montage flip-chip, la structure optique de l'étalon présentant deux pistes ou plus avec des éléments optiques et une première piste servant à générer un signal incrémentiel,
**caractérisé en ce**
- **que** la structure optique de l'étalon présente des éléments optiques de focalisation, de préférence un arrangement de réflecteurs tridimensionnels,
- **que** le récepteur de lumière est configuré comme une zone de capteurs, constituée respectivement par une multitude d'éléments récepteurs de lumière, au moins une première et une seconde zone de capteurs étant prévues, la première zone de capteurs étant configurée pour coopérer avec la première piste pour générer un signal incrémentiel et la seconde zone de capteurs étant configurée pour coopérer avec une seconde piste pour laquelle il s'agit soit d'une piste d'index, soit d'une piste codée,
- **que** la première zone de capteurs du récepteur de lumière est constituée par au moins deux éléments récepteurs de lumière qui sont placés de préférence décalés de 180° et
- **que** la seconde zone de capteurs du récepteur de lumière est formée par un premier élément récepteur de lumière allongé et par deux éléments récepteurs de lumière allongés qui sont placés substantiellement de manière symétrique et dans un angle par rapport à l'axe longitudinal du premier élément récepteur de lumière.

2. Dispositif de mesure de position selon la revendication 1, **caractérisé en ce que** la plaque de support présente, sur les deux côtés plats, des pistes conductrices pour la mise en contact avec le récepteur de lumière et pour la mise en contact avec un circuit d'évaluation, le circuit d'évaluation étant placé de préférence sur la plaque de support.

3. Dispositif de mesure de position selon la revendication 2, **caractérisé en ce que** le circuit d'évaluation est placé sur le côté de la plaque de support qui est opposé au substrat selon le procédé flip-chip, le circuit d'évaluation étant un circuit intégré pour traiter les signaux des récepteurs de lumière et les récepteurs de lumière étant reliés électriquement au circuit intégré.

4. Dispositif de mesure de position selon l'une des revendications 1 à 3, **caractérisé en ce que** la plaque de support présente un évidement dans lequel la source de lumière est logée.

5. Dispositif de mesure de position selon l'une des revendications 1 à 4, **caractérisé en ce que** le récepteur de lumière est en contact avec une couche conductrice de recouvrement et une connexion électrique est établie entre la couche conductrice de recouvrement et les pistes conductrices de la plaque de support, de préférence au moyen de billes, ce qu'il est convenu d'appeler des "bumps" ou des "stud bumps".

6. Dispositif de mesure de position selon la revendication 5, **caractérisé en ce que** la connexion entre la couche conductrice de recouvrement ou les billes d'une part et la plaque de support d'autre part est établie au moyen d'une colle qui conduit l'électricité.

7. Dispositif de mesure de position selon la revendication 6, **caractérisé en ce qu'**une résistance permanente est prévue entre la plaque de support et le substrat pour limiter l'expansion de la colle.

8. Dispositif de mesure de position selon l'une des revendications 1 à 7, **caractérisé en ce qu'**une partie des interstices existants entre le substrat transparent et la plaque de support est remplie avec un underfill, l'underfill étant de préférence substantiellement perméable à la lumière.

9. Dispositif de mesure de position selon l'une des revendications 1 à 8, **caractérisé en ce qu'**une fente d'air existe dans le passage lumineux entre la source de lumière et le substrat.

10. Dispositif de mesure de position selon l'une des revendications 6 ou 7, **caractérisé en ce que** la source de lumière, de préférence une LED, est fixée sur la couche supérieure de l'empilement de couches minces, cependant qu'un écarteur qui forme une fente définie pour la colle est prévu entre la source de lumière et la couche supérieure de l'empilement de couches minces.

11. Dispositif de mesure de position selon l'une des revendications 1 à 3 ou 5 à 8, **caractérisé en ce que** la source de lumière, de préférence une OLED, est configurée directement sur le substrat entre les récepteurs de lumière.

12. Dispositif de mesure de position selon l'une des revendications 1 à 11, **caractérisé en ce que** la plaque de support est en céramique.
